(19) Europäisches Patentamt
European Patent Office
Office européen des brevets

(11) **EP 4 773 527 A1**

(12) **EUROPEAN PATENT APPLICATION**
published in accordance with Art. 153(4) EPC

(43) Date of publication:
**08.07.2026 Bulletin 2026/28**

(21) Application number: **23952726.0**

(22) Date of filing: **22.09.2023**

(51) International Patent Classification (IPC):
**H04L 1/00** (2006.01)

(52) Cooperative Patent Classification (CPC):
**H04L 1/00**

(86) International application number:
**PCT/CN2023/120757**

(87) International publication number:
**WO 2025/060074 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **HUAWEI TECHNOLOGIES CO., LTD.**
**Shenzhen 518129 (CN)**

(72) Inventors:
• **LIU, Ke**
**Shenzhen, Guangdong 518129 (CN)**
• **ZHANG, Huazi**
**Shenzhen, Guangdong 518129 (CN)**

• **TONG, Jiajie**
**Shenzhen, Guangdong 518129 (CN)**
• **QIN, Kangjian**
**Shenzhen, Guangdong 518129 (CN)**
• **WANG, Xianbin**
**Shenzhen, Guangdong 518129 (CN)**
• **WANG, Jun**
**Shenzhen, Guangdong 518129 (CN)**
• **DU, Yinggang**
**Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **COMMUNICATION METHOD, COMMUNICATION DEVICE, COMMUNICATION APPARATUS, AND COMPUTER-READABLE STORAGE MEDIUM**

(57)     The present disclosure relates to a communication method, a communication device, a communication apparatus, and a computer-readable storage medium. The method includes: determining a lifting factor from lifting factor sets based on a length of an information bit sequence and a base matrix. The lifting factor set includes a prime number and a multiple set associated with the prime number, or the lifting factor set includes a plurality of lifting factors, and a lifting factor in the plurality of lifting factors is a product of the prime number and a multiple in the multiple set associated with the prime number. The multiple in the multiple set is a positive integer, and the multiple set includes a value not equal to $A^x$, where A is a positive integer greater than or equal to 2, and x is a nonnegative integer. The method further includes: determining a check matrix based on the lifting factor and the base matrix, where the check matrix is used to encode or decode the information bit sequence.

FIG. 7

## Description

## TECHNICAL FIELD

The present disclosure relates to the communication field, and more specifically, to a communication method for channel encoding and decoding, a communication device, a communication apparatus, a computer-readable storage medium, and a computer program product.

## BACKGROUND

Low-density parity check (low-density parity check, LDPC) codes are widely used in the field of channel encoding and decoding. Currently, in an encoding and decoding process of the LDPC codes, a check matrix needs to be generated based on a predetermined base matrix, a lifting factor set, and a shifting value set, and encoding and decoding are performed based on the check matrix. With development of communication technologies, a longer coding length needs to be supported in a future scenario. If a current design of the lifting factor set and the shifting value set is still used, stable encoding and decoding performance cannot be ensured.

## SUMMARY

In view of the foregoing problem, embodiments of the present disclosure are intended to provide a communication solution, to optimize a design of a lifting factor set, so as to ensure stable encoding and decoding performance for a longer coding length in a future scenario.

According to a first aspect of embodiments of the present disclosure, a communication method is provided. The method may be performed by a sending device, or may be performed by a receiving device. The method includes: determining a lifting factor from lifting factor sets based on a length of an information bit sequence and a base matrix, where the lifting factor set includes a prime number and a multiple set associated with the prime number, or the lifting factor set includes a plurality of lifting factors, a lifting factor in the plurality of lifting factors is a product of the prime number and a multiple in the multiple set associated with the prime number, the multiple in the multiple set is a positive integer, the multiple set includes a value not equal to $A^x$, A is a positive integer greater than or equal to 2, and x is a nonnegative integer; and determining a check matrix based on the lifting factor and the base matrix, where the check matrix is used to encode or decode the information bit sequence. Therefore, the lifting factor set based on the prime number and the multiple set in a non-exponential form can be specified, so that a quantity of shortened bits does not increase exponentially with an increase of a coding length, to achieve more stable encoding and decoding performance.

In some embodiments, the method further includes: the base matrix being one of a plurality of base matrices; determining the base matrix from the plurality of base matrices based on at least one of the length, a coding length, or a coding rate of the information bit sequence, where a base matrix in the plurality of base matrices corresponds to a lifting factor set in a plurality of lifting factor sets; and determining, based on the base matrix, the lifting factor set corresponding to the base matrix. Therefore, an appropriate base matrix and an appropriate lifting factor set can be selected according to a usage scenario, to satisfy requirements of different scenarios.

In some embodiments, a maximum value in the multiple set is determined based on a maximum value of the lifting factor and the prime number; or the maximum value in the multiple set is determined based on a maximum length of the information bit sequence, a quantity of information columns of the base matrix corresponding to the maximum length, and the prime number. Therefore, the maximum value in the multiple set in the lifting factor set can be specified or stored.

In some embodiments, the maximum value in the multiple set is associated with at least one of: a communication service type corresponding to the information bit sequence, or a hardware resource limitation. Therefore, the maximum value in the multiple set in the lifting factor set may not be specified or stored.

In some embodiments, determining the lifting factor includes: the prime number being one of a plurality of prime numbers; determining, based on at least one of the coding length of the information bit sequence or an information column length of the base matrix, a minimum multiple corresponding to each prime number in the plurality of prime numbers corresponding to the plurality of lifting factor sets; and determining the lifting factor based on a minimum value in products of all the prime numbers and the corresponding minimum multiples. Therefore, for a case in which the maximum value of the lifting factor is not specified or the maximum value of the lifting factor is set to a very large number, an appropriate lifting factor can be determined, to implement rate matching.

In some embodiments, a minimum value in the plurality of prime numbers corresponding to the plurality of lifting factor sets is associated with at least one of the following: a quantity of columns in a core part of the base matrix, where the core part includes an information column and a core check column of the base matrix; a connection relationship between the columns in the core part of the base matrix; a quantity of rows in the core part of the base matrix; or a connection relationship between the rows in the core part of the base matrix. Therefore, the minimum value in the plurality of prime numbers corresponding to the plurality of lifting factor sets can be specified.

In some embodiments, the connection relationship between the columns in the core part of the base matrix includes: Two columns grouped in a same group satisfy a quasi-orthogonal condition. In some embodiments, the connection relationship between the rows in the core part of the base matrix includes: Two rows grouped in a same group satisfy a quasi-orthogonal condition. Therefore, the core part in the base matrix can be grouped.

In some embodiments, the method further includes: determining, based on the communication service type corresponding to the information bit sequence, the lifting factor set corresponding to the communication service type, where the communication service type includes an enhanced mobile broadband (enhanced mobile broadband, eMBB) type, a massive machine type communication (massive machine type communication, mMTC) type, an ultra-reliable and low-latency communication (ultra reliable low latency communication, URLLC) type, or a high throughput type. Therefore, the lifting factor set can be selected based on a scenario, to better satisfy a scenario requirement.

In some embodiments, determining the lifting factor set includes: for the communication service type being the high throughput type, determining that the prime number corresponding to the lifting factor set includes 23, 31, or 37; or for the communication service type being the URLLC type, determining that the prime number corresponding to the lifting factor set includes 11. Therefore, prime numbers in the lifting factor sets of the high throughput type and the URLLC type can be specified.

In some embodiments, the plurality of prime numbers corresponding to the plurality of lifting factor sets include at least one of the following: consecutive prime numbers; or non-consecutive prime numbers with an interval greater than a predetermined value. Therefore, a manner of obtaining values of the plurality of prime numbers corresponding to the plurality of lifting factor sets can be specified.

In some embodiments, the consecutive prime numbers include {11, 13, 17, 19, 23}; or the non-consecutive prime numbers with the interval greater than the predetermined value include {11, 17, 23}. Therefore, some values in the plurality of prime numbers corresponding to the plurality of lifting factor sets can be specified.

In some embodiments, the multiple set includes at least one of the following: consecutive integers spaced by a predetermined interval; an integer set satisfying a piecewise linear function; a range of multiples; or a number that is not selected as the multiple in the range. Therefore, a manner of obtaining a value of an element in the multiple set corresponding to the lifting factor set can be specified.

In some embodiments, the method further includes: determining two prime numbers corresponding to the lifting factor; and selecting a minimum prime number from the two prime numbers. Therefore, a good cycle property can be ensured, and more stable encoding and decoding performance can be achieved.

In some embodiments, the lifting factor set further includes a non-prime number, and the non-prime number includes at least one of the following: 4, 6, 9, 15, 22, or 26. Therefore, different coding lengths can be better supported by combining a non-prime number and a prime number. For example, for a coding length shorter than or equal to a threshold length, a non-prime number may be used. For a coding length longer than or equal to the threshold length, a non-prime number may be used.

In some embodiments, the lifting factor set further includes an index associated with the prime number. Therefore, the shifting value set may be searched for by using the index.

In some embodiments, the method further includes: determining that the lifting factor corresponds to a plurality of indexes; and selecting an index corresponding to a minimum prime number in a plurality of prime numbers corresponding to the plurality of indexes. Therefore, the minimum prime number can be selected under a condition that the lifting factor is fixed, to ensure a good cycle property and achieve more stable encoding and decoding performance.

In some embodiments, a multiple set associated with a first index does not include a value of a prime number associated with a second index, and the second index is less than the first index; or a multiple set associated with a first prime number does not include a value of a second prime number, and the second prime number is less than the first prime number. Therefore, some elements in the multiple set may be deleted, so that there is no repeated element between the plurality of lifting factor sets.

According to a second aspect of embodiments of the present disclosure, a communication apparatus is provided. The apparatus includes: a first processing component, configured to determine a lifting factor from lifting factor sets based on a length of an information bit sequence and a base matrix, where the lifting factor set includes a prime number and a multiple set associated with the prime number, or the lifting factor set includes a plurality of lifting factors, a lifting factor in the plurality of lifting factors is a product of the prime number and a multiple in the multiple set associated with the prime number, the multiple in the multiple set is a positive integer, the multiple set includes a value not equal to $A^x$, A is a positive integer greater than or equal to 2, and x is a nonnegative integer; and a second processing component, configured to determine a check matrix based on the lifting factor and the base matrix, where the check matrix is used to encode or decode the information bit sequence.

In some embodiments, the apparatus further includes: a third processing component, configured to determine, the base matrix from a plurality of base matrices based on at least one of the length, a coding length, or a coding rate of the information bit sequence, where a base matrix in the plurality of base matrices corresponds to a lifting factor set in a plurality of lifting factor sets; and a fourth processing component, configured to determine, based on the base matrix, the lifting factor set corresponding to the base matrix.

In some embodiments, a maximum value in the multiple set is determined based on a maximum value of the lifting factor and the prime number; or the maximum value in the multiple set is determined based on a maximum length of the information bit sequence, a quantity of information columns of the base matrix corresponding to the maximum length, and the prime number.

In some embodiments, the maximum value in the multiple set is associated with at least one of: a communication service type corresponding to the information bit sequence, or a hardware resource limitation.

In some embodiments, the first processing component includes: a component configured to determine, based on at least one of the coding length of the information bit sequence or an information column length of the base matrix, a minimum multiple corresponding to each prime number in the plurality of prime numbers corresponding to the plurality of lifting factor sets; and a component configured to determine the lifting factor based on a minimum value in products of all the prime numbers and the corresponding minimum multiples.

In some embodiments, a minimum value in the plurality of prime numbers corresponding to the plurality of lifting factor sets is associated with at least one of the following: a quantity of columns in a core part of the base matrix, where the core part includes an information column and a core check column of the base matrix; a connection relationship between the columns in the core part of the base matrix; a quantity of rows in the core part of the base matrix; or a connection relationship between the rows in the core part of the base matrix.

In some embodiments, the connection relationship between the columns in the core part of the base matrix includes: Two columns grouped in a same group satisfy a quasi-orthogonal condition. In some embodiments, the connection relationship between the rows in the core part of the base matrix includes: Two rows grouped in a same group satisfy a quasi-orthogonal condition. Therefore, the core part in the base matrix can be grouped.

In some embodiments, the apparatus further includes: a fifth processing component, configured to determine, based on the communication service type corresponding to the information bit sequence, the lifting factor set corresponding to the communication service type, where the communication service type includes an eMBB type, a URLLC type, or a high throughput type.

In some embodiments, the fifth processing component includes: a component configured to: for the communication service type being the high throughput type, determine that the prime number corresponding to the lifting factor set includes 23, 31, or 37; or a component configured to: for the communication service type being the URLLC type, determine that the prime number corresponding to the lifting factor set includes 11.

In some embodiments, the plurality of prime numbers corresponding to the plurality of lifting factor sets include at least one of the following: consecutive prime numbers; or non-consecutive prime numbers with an interval greater than a predetermined value.

In some embodiments, the consecutive prime numbers include {11, 13, 17, 19, 23}; or the non-consecutive prime numbers with the interval greater than the predetermined value include {11, 17, 23}.

In some embodiments, the multiple set includes at least one of the following: consecutive integers spaced by a predetermined interval; an integer set satisfying a piecewise linear function; a range of multiples; or a number that is not selected as the multiple in the range.

In some embodiments, the apparatus further includes: a sixth processing component, configured to determine two prime numbers corresponding to the lifting factor; and a seventh processing component, configured to select a minimum prime number from the two prime numbers.

In some embodiments, the lifting factor set further includes a non-prime number, and the non-prime number includes at least one of the following: 4, 6, 9, 15, 22, or 26.

In some embodiments, the lifting factor set further includes an index associated with the prime number.

In some embodiments, the apparatus further includes: an eighth processing component, configured to determine that the lifting factor corresponds to a plurality of indexes; and a ninth processing component, configured to select an index corresponding to a minimum prime number in a plurality of prime numbers corresponding to the plurality of indexes.

In some embodiments, a multiple set associated with a first index does not include a value of a prime number associated with a second index, and the second index is less than the first index; or a multiple set associated with a first prime number does not include a value of a second prime number, and the second prime number is less than the first prime number.

According to a third aspect of embodiments of the present disclosure, a communication device is provided. The device includes a processor and a memory. The memory includes computer program code, and when the computer program code is run by the processor, the method according to the first aspect is performed.

According to a fourth aspect of embodiments of the present disclosure, a computer-readable storage medium is provided. The computer-readable storage medium includes machine-executable instructions, and when the machine-executable instructions are executed by a device, the method according to the first aspect is performed.

According to a fifth aspect of embodiments of the present disclosure, a chip is provided, including a memory and a processor. The memory is configured to store a computer program, and the processor is configured to invoke the computer program from the memory and run the computer program, to perform the method according to the first aspect.

According to a sixth aspect of embodiments of the present disclosure, a computer program product is provided. The computer program product includes computer program code, and when the computer program code is executed by a device, the method according to the first aspect is performed.

According to a seventh aspect of embodiments of the present disclosure, a communication system is provided. The communication system includes a sending device and a receiving device. The sending device performs the method according to the first aspect, to encode a to-be-sent information bit sequence. The receiving device performs the method according to the first aspect, to decode a received encoded information bit sequence.

It may be understood from the following descriptions of the example embodiments that the technical solution proposed herein can avoid an exponential increase of a quantity of shortened bits with an increase of a coding length, to achieve more stable encoding and decoding performance.

It should be understood that the content described in the summary is not intended to limit key or important features of embodiments of the present disclosure or limit the scope of the present disclosure. Other features of the present disclosure will be readily understood through the following description.

**BRIEF DESCRIPTION OF DRAWINGS**

With reference to the accompanying drawings and the following detailed descriptions, the foregoing and other features, advantages, and aspects of embodiments of the present disclosure become more apparent. In the accompanying drawings, same or similar reference numerals indicate same or similar elements.

FIG. 1 is a diagram of an example communication system in which embodiments of the present disclosure may be implemented;
FIG. 2 is a diagram of an information transmission procedure in which embodiments of the present disclosure may be implemented;
FIG. 3A and FIG. 3B are diagrams of a structure of a base matrix in which embodiments of the present disclosure may be implemented;
FIG. 4 is a diagram of lifting factor sets according to the conventional solution;
FIG. 5 is a diagram of shifting value sets according to the conventional solution;
FIG. 6A is a diagram of an example lifting factor set according to an embodiment of the present disclosure;
FIG. 6B is a diagram of another example lifting factor set according to an embodiment of the present disclosure;
FIG. 6C is a diagram of still another example lifting factor set according to an embodiment of the present disclosure;
FIG. 7 is a diagram of a communication process according to an embodiment of the present disclosure;
FIG. 8 is a diagram of an example process of determining a lifting factor set according to an embodiment of the present disclosure;
FIG. 9A is a diagram of a simulation result of a quantity of shortened bits varying with a length of an information bit sequence according to an embodiment of the present disclosure;
FIG. 9B is a diagram of another simulation result of a quantity of shortened bits varying with a length of an information bit sequence according to an embodiment of the present disclosure;
FIG. 10 is a diagram of a simulation result of a relationship between a maximum value of a lifting factor supported by hardware and an actually supported maximum length of an information bit sequence according to an embodiment of the present disclosure;
FIG. 11 is a flowchart of a communication method according to an embodiment of the present disclosure;
FIG. 12 is a block diagram of a communication apparatus according to an embodiment of the present disclosure; and
FIG. 13 is a simplified block diagram of a communication device suitable for implementing embodiments of the present disclosure.

**DESCRIPTION OF EMBODIMENTS**

Embodiments of the present disclosure are described in more detail in the following with reference to the accompanying drawings. Although some embodiments of the present disclosure are shown in the accompanying drawings, it should be understood that the present disclosure can be implemented in various forms, and should not be construed as being limited to embodiments described herein, and instead, these embodiments are provided for a more thorough and complete understanding of the present disclosure. It should be understood that the accompanying drawings and embodiments of the present disclosure are merely used as examples and are not intended to limit the protection scope of the present disclosure.

In the descriptions of embodiments of the present disclosure, the term "including" and similar terms thereof shall be understood as non-exclusive inclusions, that is, "including but not limited to". The term "based on" should be understood as "at least partially based on". The term "one embodiment" or "this embodiment" should be understood as "at least one embodiment". The terms "first", "second", and the like may indicate different objects or a same object. The term "and/or" indicates at least one of two items associated with the term. For example, "A and/or B" indicates A, B, or A and B. The following may further include other explicit and implied definitions.

It should be understood that in the technical solutions provided in embodiments of this application, some repeated parts may not be described again in the following descriptions of specific embodiments, but it should be considered that these specific embodiments are mutually referenced and may be combined.

The term "circuit" used herein refers to one or more of the following:

(a) hardware circuit implementation only (such as implementations of analog and/or digital circuits only);

(b) a combination of hardware circuit and software, for example (if applicable): (i) a combination of analog and/or digital hardware circuits and software/firmware, and (ii) any part of a hardware processor and software (including a digital signal processor, software, and a memory that work together to enable an apparatus like an optical line terminal (optical line terminal, OLT) or another compute device to perform various functions); and

(c) a hardware circuit and/or a processor, such as a microprocessor or a part of a microprocessor, which requires software (such as firmware) for operation, but may not have software when software is not required for operation.

The definition of a circuit is applicable to all scenarios of use of the term in this application (including any claim). In another example, the term "circuit" used herein also covers implementations of only a hardware circuit or processor (or a plurality of processors), a part of a hardware circuit or processor, or software or firmware accompanying a hardware circuit or processor. For example, if the term "circuit" is applicable to a particular claim element, the term "circuit" further covers a baseband integrated circuit, a processor integrated circuit, an OLT, or a similar integrated circuit in another compute device.

As used in this specification, the term "terminal device" is any device that has a wireless or wired communication capability. Examples of the terminal device include but are limited to customer premises equipment (customer premise equipment, CPE), user equipment (user equipment, UE), a personal computer, a desktop computer, a mobile phone, a cellular phone, a smartphone, a personal digital assistant (personal digital assistant, PDA), a portable computer, a tablet, a wearable device, an IoT device, a machine type communication (machine type communication, MTC) device, a vehicle-mounted device for vehicle-to-everything (vehicle-to-everything, V2X) (X refers to a pedestrian, a vehicle, or an infrastructure/network) communication, an image capture device such as a digital camera, a game device, a music storage and playback device, or an internet device capable of wireless or wired internet access and browsing.

In addition, the term "access network device" may be a node in a radio access network (radio access network, RAN), and is a device that can provide or host a cell or coverage area in which a terminal device can perform communication. Examples of the access network device include but are not limited to a NodeB (NodeB or NB), an evolved NodeB (evolved NodeB, eNodeB), a next generation NodeB (next generation NodeB, gNB), a transmission reception point (transmission reception point, TRP), a remote radio unit (remote radio unit, RRU), a radio head (radio head, RH), a remote radio head (remote radio head, RRH), or a low power node such as a femto node or a pico node.

In addition, the term "core network device" may be a node in a core network (core network, CN), and may have a control plane function, a user plane function, or both. Examples of the core network device include but are not limited to a session management function (session management function, SMF), an access management function (access management function, AMF), a policy control function (policy control function, PCF), a user plane function (user plane function, UPF), a network exposure function (network exposure function, NEF), an application function (application function, AF), or the like.

In this application, "sending information to... (a terminal)" may be understood as: a destination end of the information is the terminal, and may include directly or indirectly sending the information to the terminal. "Receiving information from... (a terminal)" may be understood as that a source end of the information is the terminal, and may include directly or indirectly receiving the information from the terminal. For example, directly sending the information to the terminal may mean that the information is sent to the terminal through an air interface, and indirectly sending the information to the terminal may mean that the information is processed before being sent through the air interface (for example, the information is output after being processed by a processor at a transmitting end). Similarly, directly receiving the information from the terminal may mean that the information from the terminal is received by a receiving end through an air interface, and indirectly receiving the information from the terminal may mean that the information from the terminal is transmitted through the air interface and processed (for example, the information is received by an antenna or undergoes radio frequency processing), and then is input to a processor at the receiving end, or is received by the processor at the receiving end. "Sending information to... (an access network device/a network device)" may be understood as: a destination end of the information is the access network device/the network device, and may include directly or indirectly sending the information to the access network device/the network device. "Receiving information from... (an access network device/a network device)" may be understood as: a source end of the information is the access network device/the network device, and may include directly or indirectly receiving information from the access network device/the network device. For example, directly sending the information to the access network device/the network device may mean that the information is sent to the access network device/network device through an air interface, and indirectly sending the information to the access network device/the network device may mean that the information is processed before being sent through the air interface (for example, the information is output after being processed by a processor at a transmitting end). Similarly, directly receiving the information from the access network device/the network device may mean that the information from the access network device/the network device is received by a receiving end through an air interface, and indirectly receiving the information from the access network device/the network device may mean that the information from the access network device/the network device is transmitted through the air interface and processed (for example, the information is received by an antenna or undergoes radio frequency processing), and then is input to a processor at the receiving end, or is received by the processor at the receiving end. Information may undergo necessary processing, for example, a format change, between a source end for sending the information and a destination end. However, the destination end may understand valid information from the source end. A similar expression in this application may be understood similarly, and details are not described herein again.

In the context of the present disclosure, an information bit sequence may be a to-be-encoded information bit sequence (or payload bits (payload bits)), or the information bit sequence may be an information bit sequence obtained by concatenated encoding. For example, the information bit sequence may include a cyclic redundancy check (cyclic redundancy check, CRC) bit. In some embodiments, a length of the information bit sequence may be a length of the to-be-encoded information bit sequence. In some embodiments, the length of the information bit sequence may be a length of the information bit sequence obtained by concatenated encoding. For example, the length of the information bit sequence may be a length of the information bit sequence including the CRC bit. In the context of the present disclosure, the terms "information bit" may be used interchangeably with "information bit sequence".

In the context of the present disclosure, the term "check matrix" is a matrix used for encoding or decoding an information bit sequence. The term "check matrix" may be used interchangeably with "encoding matrix", "decoding matrix", or "Tanner graph". Certainly, the check matrix may also have another name. In the context of the present disclosure, the term "communication service type" may be used interchangeably with "communication service scenario", "communication scenario", "scenario", "type", "communication type", or "service type". In the context of the present disclosure, the terms "base matrix" may be used interchangeably with "base graph (base graph, BG)". The term "lifting factor" may be used interchangeably with "extension factor", "lifting value", "extension value", "extension coefficient", or "lifting size".

In the context of the present disclosure, the term "Tanner graph" is a matrix obtained by performing quasi cyclic (quasi cyclic, QC) extension on a base graph by using a lifting factor. The term "cycle" is a structure that starts from a vertex, passes through non-repeated vertexes along non-repeated edges, and finally returns to a starting point in a Tanner graph. The term "short cycle" is a cycle with a short length. The term "girth" is a length of a shortest cycle in a Tanner graph. The term "cycle property" is existence of short cycles, a quantity of short cycles, and/or a structural relationship between the short cycles. A good cycle property may mean that at least one of the following is satisfied: a large girth (for example, absence of cycle of length 4 is ensured), a small quantity of short cycles (for example, a cycle of length 6 or a cycle of length 8), or a large distance between short cycles (for example, a cycle of length 6 and a cycle of length 8 overlap by at most one variable node).

As described above, in both an encoding or decoding process, a check matrix needs to be generated based on a predetermined base matrix, a lifting factor set, and a shifting value set. However, a lifting factor in a current lifting factor set increases exponentially with an increase of a coding length. Rate matching further increases a quantity of shortened bits exponentially. Consequently, degree distribution is damaged, and integrity of the base matrix is damaged, resulting in performance deterioration.

In view of this, an embodiment of the present disclosure provides a solution of designing a lifting factor set based on both a prime number and a multiple set in a non-exponential form. In one aspect, the lifting factor set may include a prime number and a multiple set associated with the prime number. In another aspect, the lifting factor set may include a plurality of lifting factors, and a lifting factor in the plurality of lifting factors is a product of the prime number and a multiple in the multiple set associated with the prime number. The multiple in the multiple set is a positive integer, and the multiple set includes a value not equal to $A^x$, where A is a positive integer greater than or equal to 2, and x is a nonnegative integer.

Accordingly, embodiments of the present disclosure propose a coding scheme implemented at a sending device. In the coding scheme, the sending device may determine, based on a length of an information bit sequence and a base matrix, a lifting factor from lifting factor sets that are based on prime numbers. The sending device may determine a check matrix based on the lifting factor and the base matrix, to encode the information bit sequence.

Embodiments of the present disclosure further propose a decoding scheme implemented at a receiving device. In the decoding scheme, the receiving device may determine, based on the length of the information bit sequence and the base matrix, the lifting factor from the lifting factor sets that are based on the prime numbers. The receiving device may determine a check matrix based on the lifting factor and the base matrix, to decode the information bit sequence.

According to the solution of this embodiment of the present disclosure, the lifting factor set based on the prime number and the multiple set in the non-exponential form is designed, so that a quantity of to-be-shortened bits does not increase exponentially with an increase of a coding length. Therefore, more stable encoding and decoding performance can be achieved.

For ease of understanding, the following describes this solution in detail with reference to the accompanying drawings.

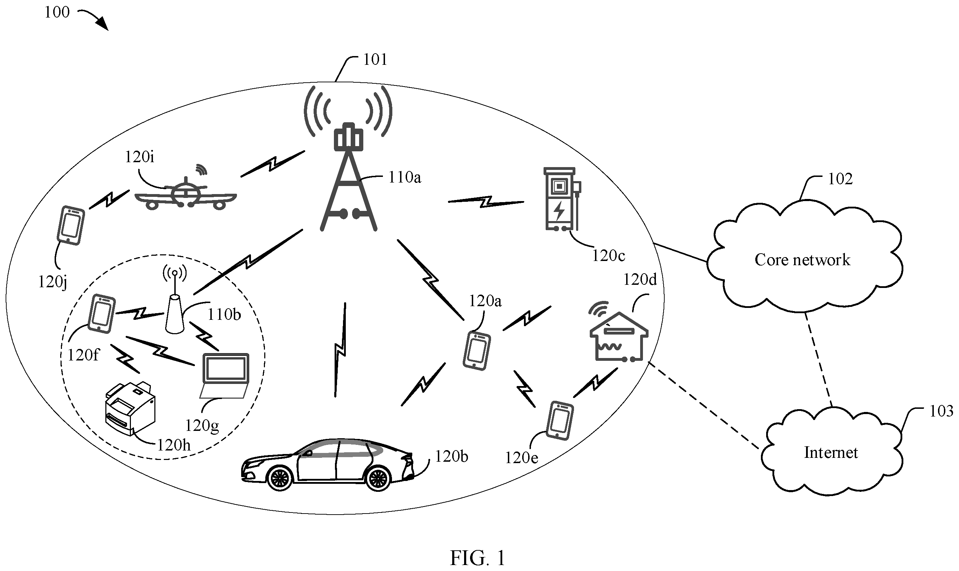

FIG. 1 is a diagram of an example communication system 100 in which embodiments of the present disclosure may be implemented. It should be understood that FIG. 1 is a possible and non-limiting diagram of a system. As shown in FIG. 1, the communication system 100 includes a radio access network (radio access network, RAN) 101 and a core network (core network, CN) 102. Optionally, the communication system 100 may further include the internet 103. The RAN 101 includes at least one RAN node (for example, 110a and 110b in FIG. 1, which are collectively referred to as 110) and at least one terminal (for example, 120a to 120j in FIG. 1, which are collectively referred to as 120). The RAN 101 may further include other RAN nodes, for example, a wireless relay device and/or a wireless backhaul device (not shown in FIG. 1). The terminal 120 is connected to the RAN node 110 in a wireless manner. The RAN node 110 is connected to the core network 102 in a wireless or wired manner. A core network device in the core network 102 and the RAN node 110 in the RAN 101 may be different physical devices, or may be a same physical device that integrates core network logical functions and radio access network logical functions, or one device may integrate some of the core network logical functions and some of the radio access network logical functions. The terminals may be connected to each other in a wired or wireless manner and the RAN nodes may be connected to each other in a wired or wireless manner. FIG. 1 is merely a diagram. The communication system may further include another network device, for example, may further include a relay device and a backhaul device, which are not shown in FIG. 1.

The RAN 101 may be a cellular system related to the 3rd generation partnership project (3rd generation partnership project, 3GPP), for example, a 4G mobile communication system, a 5G mobile communication system, or a future-oriented evolved system (for example, a 6G mobile communication system). The RAN 101 may alternatively be an open access network (open RAN, O-RAN or ORAN), a cloud radio access network (cloud radio access network, CRAN), or a wireless fidelity (wireless fidelity, Wi-Fi) system. The RAN 101 may alternatively be a communication system that integrates two or more of the foregoing systems.

The RAN node 110 may also be referred to as an access network device, a RAN entity, an access node, or the like sometimes, and forms a part of the communication system, to help the terminal implement radio access. A plurality of RAN nodes 110 in the communication system 100 may be nodes of a same type, or may be nodes of different types. In some scenarios, roles of the RAN node 110 and the terminal 120 are relative to each other. For example, the network element 120i in FIG. 1 may be a helicopter or an uncrewed aerial vehicle, and may be configured as a mobile base station. For the terminal 120j that accesses the RAN 101 through the network element 120i, the network element 120i is a base station. However, for the base station 110a, the network element 120i is a terminal. Sometimes, the RAN node 110 and the terminal 120 are both referred to as communication devices. For example, the network elements 110a and 110b in FIG. 1 may be understood as communication devices having a base station function, and the network elements 120a to 120j may be understood as communication devices having a terminal function.

In a possible scenario, the RAN node may be a base station (base station, BS), an evolved NodeB (evolved NodeB, eNodeB), an access point (access point, AP), a transmission reception point (transmission reception point, TRP), a next generation NodeB (next generation NodeB, gNB), a next generation base station in a 6th generation (6th generation, 6G) mobile communication system, a base station in a future mobile communication system, an access node in a Wi-Fi system, or the like. The RAN node may be a macro base station (for example, 110a in FIG. 1), a micro base station or an indoor station (for example, 110b in FIG. 1), a relay node or a donor node, or a radio controller in a CRAN scenario. Optionally, the RAN node may alternatively be a server, a wearable device, a vehicle, a vehicle-mounted device, or the like. For example, an access network device in a vehicle to everything (vehicle to everything, V2X) technology may be a road side unit (road side unit, RSU). All or a part of functions of the RAN node in this application may alternatively be implemented by using a software function running on hardware, or may be implemented by using a virtualization function instantiated on a platform (for example, a cloud platform). Alternatively, the RAN node in this application may be a logical node, a logical module, or software that can implement all or a part of functions of the RAN node.

In another possible scenario, the plurality of RAN nodes cooperate to assist the terminal in implementing radio access, and different RAN nodes separately implement a part of functions of a base station. For example, the RAN node may be a central unit (central unit, CU), a distributed unit (distributed unit, DU), a CU-control plane (control plane, CP), a CU-user plane (user plane, UP), a radio unit (radio unit, RU), or the like. The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may also have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of a software module and a hardware module. A specific technology and a specific device form that are used by the RAN node are not limited in embodiments of this application.

The terminal may alternatively be referred to as a terminal device, user equipment (user equipment, UE), a mobile station, a mobile terminal, or the like. The terminal may be widely used in various scenarios, for example, device-to-device (device-to-device, D2D), vehicle to everything (vehicle to everything, V2X) communication, machine-type communication (machine-type communication, MTC), internet of things (internet of things, IOT), virtual reality, augmented reality, industrial control, automatic driving, telemedicine, a smart grid, smart furniture, a smart office, smart wearable, smart transportation, and a smart city. The terminal may be a mobile phone, a tablet computer, a computer with a wireless transceiver function, a wearable device, a vehicle, an uncrewed aerial vehicle, a helicopter, an airplane, a ship, a robot, a robot arm, a smart home device, or the like. A device form of the terminal is not limited in embodiments of this application.

The core network 102 may include one or more core network devices (not shown). Examples of the core network device include but are not limited to a session management function (session management function, SMF), an access management function (access management function, AMF), a policy control function (policy control function, PCF), a user plane function (user plane function, UPF), a network exposure function (network exposure function, NEF), an application function (application function, AF), or the like.

The internet 103 may include one or more servers (not shown), configured to provide various business services.

It should be understood that a quantity of devices in FIG. 1 is provided for the purpose of description, and does not imply any limitation to this application. The communication system 100 may include any appropriate quantity of access network devices and/or core network devices and/or terminal devices that are suitable for implementing this application. In addition, the communication system 100 may include more additional components that are not shown, or some shown components may be omitted. This is not limited in embodiments of this application. An implementation of the communication system 100 is also not limited to the specific examples described above, but the communication system 100 may be implemented in any appropriate manner.

A communication device in the communication system 100 may be compatible with any suitable standard, including but not limited to a global system for mobile communication (global system for mobile communication, GSM), long term evolution (long term evolution, LTE), LTE evolution, LTE-advanced (LTE-advanced, LTE-A), wideband code division multiple access (wideband code division multiple access, WCDMA), a code division multiple access (code division multiple access, CDMA) system, an enhanced data rate for GSM evolution (enhanced data rate for GSM evolution, EDGE) system, and the like. In addition, the communication device in the communication system 100 may perform communication according to communication protocols of any generation of standard to be developed in the future, for example, a sixth generation (sixth generation, 6G) communication protocol. An example of the communication protocol includes but is not limited to a first generation (first generation, 1G), second generation (second generation, 2G), 2.5G, 2.75G, third generation (third generation, 3G), fourth generation (fourth generation, 4G), 4.5G, fifth generation (fifth generation, 5G), or sixth generation communication protocol.

Embodiments of the present disclosure may be applied to any communication device in the communication system 100, for example, the terminal 120, the RAN node 110, the core network device, or the server. In other words, embodiments of the present disclosure may be applied to a sending device and/or a receiving device in an information transmission process.

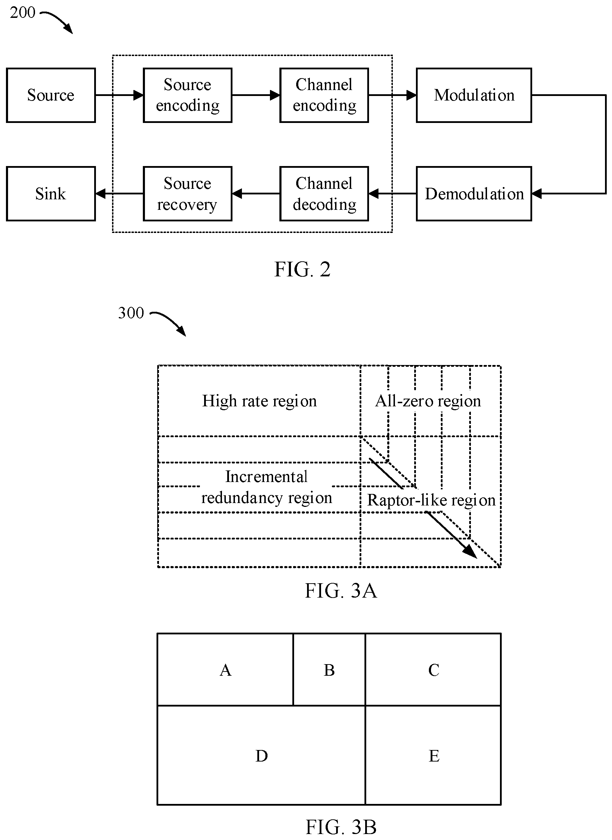

FIG. 2 is a diagram of an information transmission procedure 200 in which embodiments of the present disclosure may be implemented. As shown in FIG. 2, information is sent by a source, and arrives at a sink after processing such as source encoding, channel encoding, modulation, air interface transmission, demodulation, channel decoding, and source recovery, to complete information transmission from the source to the sink. In FIG. 2, processing (including the source encoding, the channel encoding, the modulation, and the like) shown at an upper layer is performed at a sending device, and processing (including the demodulation, the channel decoding, the source recovery, and the like) shown at a lower layer is performed at a receiving device. Embodiments of the present disclosure mainly relate to the encoding or decoding process shown in FIG. 2, for example, the source encoding, the channel encoding, the channel decoding, or the source recovery.

Currently, LDPC codes are determined by the third generation partnership project (the third generation partnership project, 3GPP) as a channel coding scheme of the fifth generation mobile communication technology (the fifth generation mobile communication technology, 5G). The LDPC codes are a channel coding scheme that is near to the Shannon limit, and has characteristics such as good performance and low complexity.

Encoding of the LDPC codes is performed by generating a check matrix. A mainstream LDPC code has a quasi cyclic (quasi cyclic, QC) structure, and is also referred to as a QC-LDPC code. A check matrix is generated by setting a shifting amount for each block of a base matrix, to avoid a bad structure such as a short cycle, and increase a code distance. Currently, a decoding algorithm of the LDPC code mainly includes a minimum sum (min-sum, MS) decoding algorithm and a belief propagation (belief propagation, BP) decoding algorithm. In terms of decoding performance, the BP decoding algorithm is better. However, the BP decoding algorithm has a large amount of information storage and a complex calculation manner, and is not conducive to hardware implementation. Therefore, currently, an offset MS decoding algorithm and a normalized MS decoding algorithm are actually used in the communication system.

FIG. 3A and FIG. 3B are diagrams of a structure of a base matrix 300 in which embodiments of the present disclosure may be implemented. As shown in FIG. 3A, the base matrix 300 may include a high rate region (high rate region), an all-zero region, an incremental redundancy region (incremental redundancy region), and a raptor-like region (raptor-like region). The high rate region may include a part A and a part B shown in FIG. 3B. The part A corresponds to an information bit (or referred to as an information bit, a system bit, or the like), and the part B is a square matrix and corresponds to a core check bit (or referred to as a core check bit). The all-zero region may correspond to a part C shown in FIG. 3B, and is an all-zero matrix. The incremental redundancy region may correspond to a part D in FIG. 3B. The raptor-like region may correspond to a part E in FIG. 3B, may be an identity matrix, and corresponds to a check bit extended at a low coding rate.

The base matrix 300 uses a "raptor-like" structure, and may be gradually extended to a low coding rate by using a core matrix with a high coding rate. In actual use, as shown in FIG. 3A, the first X rows and the first Y columns of the base matrix may be intercepted. As a coding rate decreases, X and Y gradually increase, and a used region of the matrix also gradually increases.

A core row of the base matrix 300 is a row corresponding to a core check bit. In other words, the core row is a row corresponding to the high rate region. A core column of the base matrix 300 is all information columns and all core check columns. In other words, the core column is a column corresponding to the high rate region, or a column corresponding to the part A and the part B. A core matrix of the base matrix 300 is a part including all core rows and all core columns of the base matrix. In other words, the core matrix is a high rate region of the base matrix 300, or a part including the part A and the part B. A core part of the base matrix 300 is a part including all rows and all core columns of the base matrix 300. In other words, the core part is a region including the high rate region and the raptor-like region, a region including the part A, the part B, and the part D, or a region corresponding to a non-raptor-like node. An extended region (also referred to as an extended matrix or an extended part) of the base matrix 300 is the incremental redundancy region or the part D.

It should be noted that a structure of the check matrix is similar to a structure of the base matrix, and details are not described herein again.

Currently, an actually used QC-LDPC code is to extend 1 in the base matrix to a cyclic shifting matrix. A BG model of the QC-LDPC code may be represented by Formula (1):

$$BG=(X, Y, F) \qquad (1)$$

X represents a variable, Y represents a check equation, and F represents an edge relationship of the BG.

A check matrix may be obtained by performing QC extension on the BG by using a lifting factor. A check matrix G may be represented by Formula (2):

$$G=(V, C, E) \qquad (2)$$

V represents a variable node, C represents a check node, and E represents an edge relationship of G.

A quantity of columns of the check matrix may be represented by Formula (3):

$$N=|V|=Zc|X| \qquad (3)$$

N represents the quantity of columns of the check matrix, V represents the variable node, Zc represents a lifting factor, and X represents a row of the check matrix.

A quantity of rows of the check matrix may be represented by Formula (4):

$$M=|C|=Zc|Y| \qquad (4)$$

M represents the quantity of rows of the check matrix, C represents the check node, Zc represents the lifting factor, and Y represents a column of the check matrix.

A quantity of non-zero elements in the check matrix may be represented by Formula (5):

$$|E| = Zc|F| \qquad (5)$$

E represents the quantity of non-zero elements in the check matrix, Zc represents the lifting factor, and F represents the edge relationship of the BG.

Currently, a range of information bits supported by a 5G data channel is 1 to 8448, and two BGs: a $BG_1$ and a $BG_2$ are specified. A same BG needs to use different lifting factors to adapt to rate matching of different coding lengths. Therefore, a lifting factor set and a shifting value set need to be stored, and a manner of performing rate matching based on the lifting factor set and the shifting value set needs to be stored.

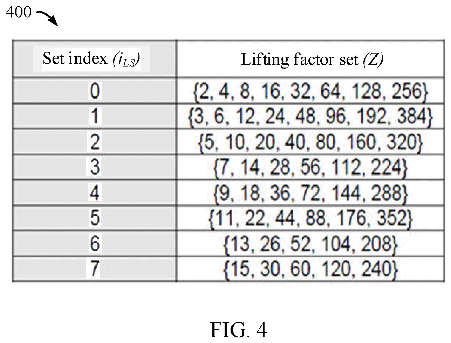

FIG. 4 is a diagram 400 of lifting factor sets according to the conventional solution. It can be learned that a $j^{th}$ row of the lifting factor sets is $a_j \times 2^{kj}$, where $a_j \in \{2,3,5,7,9,11,13,15\}$, max $(k_j) \in \{7,7,6,5,5,5,4,4\}$, j is a positive integer, and $k_j$ is a nonnegative integer.

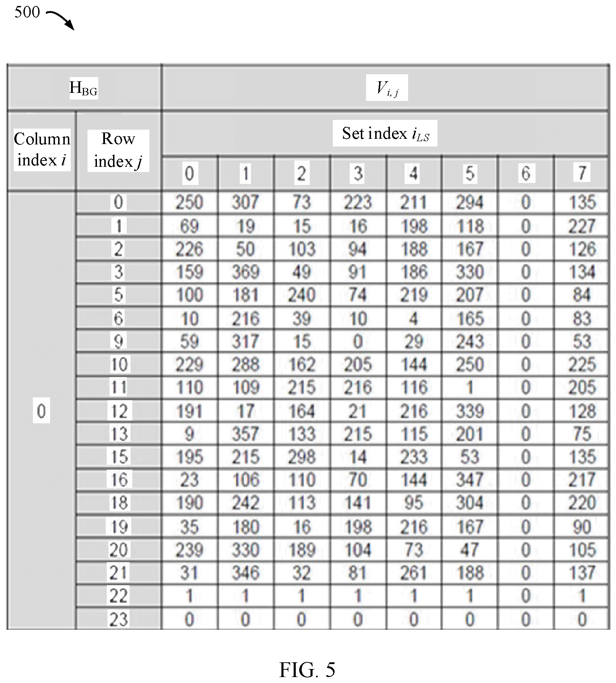

FIG. 5 is a diagram 500 of shifting value sets according to the conventional solution. As shown in FIG. 5, $H_{BG}$ represents a non-zero position (also referred to as a non-zero element) of the base matrix, $V_{i,j}$ represents a shifting value for an element in an $i^{th}$ row and a $j^{th}$ column of the base matrix $H_{BG}$, and $i_{LS}$ represents a set index of the lifting factor set Z in FIG. 4. It can be seen that the lifting factors $a_j \times 2^{kj}$ in each row in FIG. 4 share a same group of shifting values.

During rate matching, a lifting factor may be selected from the plurality of lifting factor sets Z shown in FIG. 4 based on a length of a to-be-sent or received information bit sequence and a quantity of information columns in the base matrix. Based on a set index $i_{LS}$ of a lifting factor set Z including the lifting factor, a shifting value set corresponding to the set index $i_{LS}$ may be determined from the plurality of shifting value sets corresponding to the plurality of set indexes in FIG. 5. For example, if a lifting factor selected from the lifting factor sets in FIG. 4 is 128, it is determined that a set index $i_{LS}$ is 0. Then, a group of shifting values corresponding to the set index $i_{LS}$ 0 may be determined from the shifting value set in FIG. 5, to extend an element in a corresponding column of a row 0 of the base matrix. In this manner, a check matrix may be generated.

However, as shown in FIG. 4, a design of a lifting factor in a current lifting factor set is based on an exponential form. As a coding length increases, the lifting factor also increases exponentially. Rate matching further increases a quantity of shortened bits exponentially. Consequently, degree distribution is damaged, and integrity of the base matrix is damaged, resulting in performance deterioration.

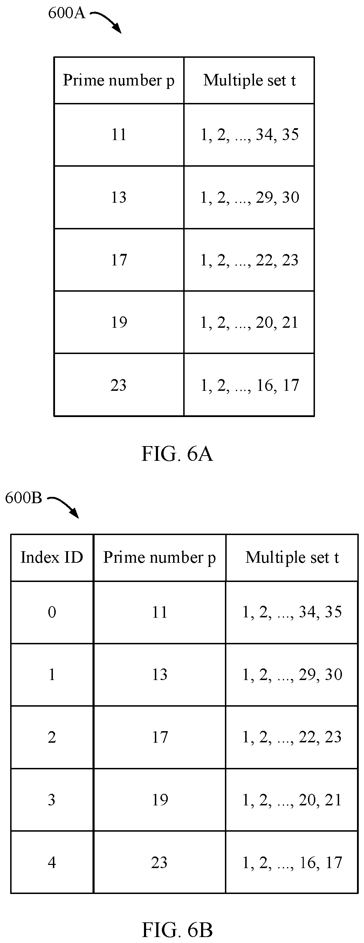

In view of this, an embodiment of the present disclosure provides a solution of designing a lifting factor set based on both a prime number and a multiple set in a non-exponential form. The prime number is a positive integer that has no other factor except 1 and itself. The multiple set in the non-exponential form means that a multiple in the multiple set is a positive integer, and the multiple set includes a value not equal to $A^x$, where A is a positive integer greater than or equal to 2, and x is a nonnegative integer. In some embodiments, in addition to a value not equal to $A^x$, the multiple set may further include a value equal to $A^x$. The following describes this solution in detail with reference to FIG. 6A to FIG. 6C.

In some embodiments, the lifting factor set may include a prime number and a multiple set associated with the prime number. A multiple in the multiple set is a positive integer, and the multiple set includes a value not equal to $A^x$, where A is a positive integer greater than or equal to 2, and x is a nonnegative integer. That is, the lifting factor may be stored in a form of a prime number and a multiple set. In this case, the lifting factor set and a shifting value set may be associated by the prime number. FIG. 6A is a diagram of an example lifting factor set 600A according to an embodiment of the present disclosure. As shown in FIG. 6A, the lifting factor set 600A includes a plurality of lifting factor sets in a plurality of rows. Each lifting factor set includes a prime number p and a multiple set t associated with the prime number p. A plurality of prime numbers p corresponding to the plurality of lifting factor sets form a prime number set.

In some embodiments, the lifting factor set may include a prime number, an index associated with the prime number, and a multiple set associated with the prime number. A multiple in the multiple set is a positive integer, and the multiple set includes a value not equal to $A^x$, where A is a positive integer greater than or equal to 2, and x is a nonnegative integer. That is, the lifting factor may be stored in a form of a prime number, an index, and a multiple set. In this case, the lifting factor set and a shifting value set may be associated by an index or a prime number. FIG. 6B is a diagram of an example lifting factor set 600B according to an embodiment of the present disclosure. As shown in FIG. 6B, the lifting factor set 600B includes a plurality of lifting factor sets in a plurality of rows. Each lifting factor set includes a prime number p, an index ID associated with the prime number p, and a multiple set t associated with the prime number p. A plurality of prime numbers p corresponding to the plurality of lifting factor sets form a prime number set. In the example of FIG. 6B, as the index ID increases, the prime number p gradually increases. It should be understood that embodiments of the present disclosure are not limited thereto. In some embodiments, as the index ID increases, the prime number p may gradually decrease.

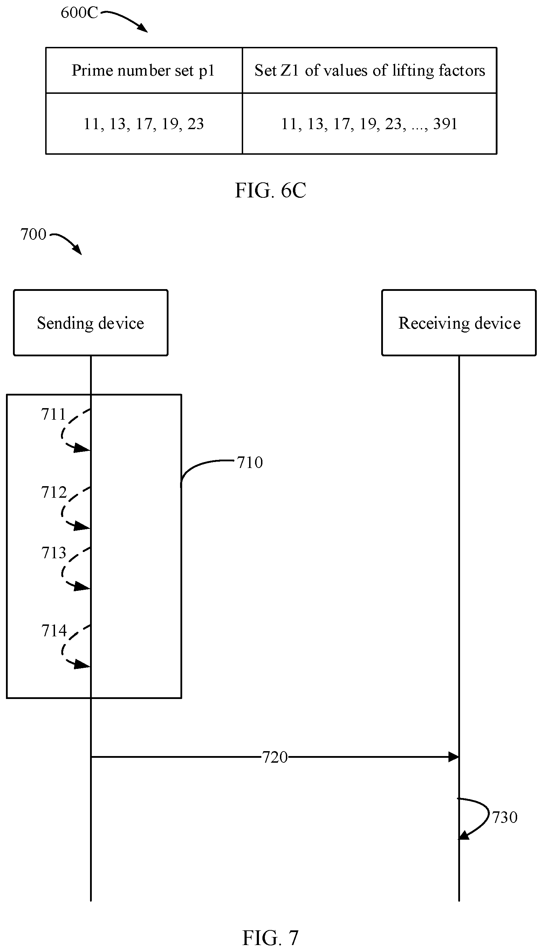

In some embodiments, the lifting factor set may include a plurality of lifting factors, and a lifting factor in the plurality of lifting factors is a product of a prime number and a multiple in a multiple set associated with the prime number. The multiple in the multiple set is a positive integer, and the multiple set includes a value not equal to $A^x$, where A is a positive integer greater than or equal to 2, and x is a nonnegative integer. That is, the lifting factors may be directly stored. In some embodiments, a set of all prime numbers associated with the lifting factor set may also be stored. In this case, the lifting factor set and a shifting value set may be associated by a prime number. FIG. 6C is a diagram of an example lifting factor set 600C according to an embodiment of the present disclosure. As shown in FIG. 6C, the lifting factor set 600C may include a set Z1 of values of lifting factors and a set p1 of associated prime numbers. Each value in the set Z1 is a product of a corresponding prime number in the prime number set p1 and a corresponding multiple in the multiple set. It should be understood that, although the prime number set p1 is shown in the example in FIG. 6C, in some embodiments, the lifting factor set may include only the set Z1 of the values of the lifting factors.

In this manner, a lifting factor may be a product of a prime number and a multiple in the multiple set. For example, the lifting factor may be expressed as Formula (6):

$$Zc = p \times t \qquad (6)$$

Zc represents a lifting factor, p represents a prime number, and t represents a multiple in the multiple set.

Because the multiples in the multiple set do not increase exponentially, lifting factors corresponding to prime numbers do not increase exponentially, either. Therefore, more stable encoding and decoding performance can be achieved.

The following describes an implementation of the multiple set according to an embodiment of the present disclosure. First, a value feature of the multiple set is described. In some embodiments, the multiple set may include consecutive integers spaced by a predetermined interval. In some embodiments, the predetermined interval may be 1. That is, the multiple set may include consecutive integers with an interval of 1, for example, a multiple set {1, 2, ..., 35} shown in FIG. 6A and FIG. 6B. In some embodiments, the predetermined interval may be 2. For example, the multiple set may be {1, 3, 5, 7, 9}. It should be understood that the predetermined interval may be any proper positive integer. This is not limited in this embodiment of the present disclosure. In this manner, the multiples are consecutive integers, an interval between elements in the lifting factor set is a fixed constant, and a quantity of shortened bits may not increase with an increase of a coding length.

In some embodiments, the multiple set may include an integer set satisfying a piecewise linear function. In some embodiments, the multiple set may include non-consecutive integers with gradually increasing intervals. For example, the multiple set may include {1:1:8, 10:2:16, 19:3:25}. In this example, the multiple set is a concatenation of three linear functions, and a slope of each linear function changes. If a segment number increases with a value, a slope of each segment increases with the increase of the segment number, and endpoints of adjacent segments are either identical or an endpoint of each segment differs from a current slope value by a factor of 2. The multiple set is designed in this manner, so that hardware implementation complexity can be reduced. In addition, as the coding length increases, the intervals between the lifting factors increase appropriately (that is, increases according to a piecewise linear function) without performance loss. In some embodiments, the multiple set may alternatively include non-consecutive integers with gradually decreasing intervals.

In some embodiments, the multiple set may include a range of multiples. In other words, a maximum value and a minimum value of the multiples may be directly stored to limit the range of the multiples. In this case, all integers in the range can be selected as the multiple. In this way, the multiple set can be described briefly without performance loss.

In some embodiments, in addition to the maximum value and the minimum value of the multiples, the multiple set may further include a number that is not selected as a multiple in the foregoing range. In this manner, the multiple set can be described more accurately.

It is assumed that the lifting factor set is described in the form of an index, a prime number, and a multiple set as shown in FIG. 6B. In some embodiments, a multiple set corresponding to each index may be arranged in ascending order. In some embodiments, a multiple set corresponding to each index may be arranged in descending order. In some embodiments, the multiple set may be modulated into a higher order symbol for storage and description.

The following describes a maximum value in the multiple set. In some embodiments, the maximum value in the multiple set may be determined based on a maximum value of the lifting factor and the prime number. The maximum value of the lifting factor may be a maximum lifting factor in all lifting factor sets. Optionally, the maximum value of the lifting factor may alternatively be a maximum value specified by a system, for example, a system limitation. In some embodiments, a maximum value in the multiple set corresponding to each prime number may be expressed as Formula (7):

$$t_{max} = \left\lceil \frac{Z_{max}}{p} \right\rceil \qquad (7)$$

p represents the prime number, $t_{max}$ represents the maximum value in the multiple set corresponding to the prime number p, and $Z_{max}$ represents a maximum value of the lifting factor. In this case, as the prime number increases, a maximum value in a corresponding multiple set presents a decreasing trend.

In some embodiments, the maximum value in the multiple set may be determined based on a maximum length of an information bit sequence, a quantity of information columns of the base matrix corresponding to the maximum length, and the prime number. In some embodiments, the maximum value of the lifting factor may be described by using the maximum length of the information bit sequence and the information columns of the base matrix. For example, the maximum value of the lifting factor may be expressed as Formula (8):

$$Z_{max} = \frac{K_{max}}{kb} \qquad (8)$$

$Z_{max}$ represents the maximum value of the lifting factor, $K_{max}$ represents the maximum length of the information bit sequence, and $kb$ represents a quantity of information columns of the base matrix in a case of the maximum length of the information bit sequence.

In some embodiments, the maximum value of the lifting factor may be an integer multiple, for example, twice, of a maximum value of a lifting factor in each row of a 5G lifting factor set (as shown in FIG. 4). For example, the maximum value of the lifting factor may be selected from {768, 512, 640, 448, 576, 704, 416, 480}. After the maximum value of the lifting factor is determined, the maximum value $t_{max}$ in the multiple set corresponding to each prime number or index may be obtained according to Formula (7).

The foregoing describes the maximum value in the multiple set when the maximum value of the lifting factor is specified. In some alternative embodiments, the maximum value in the multiple set may be described when the maximum value of the lifting factor is not specified. In some embodiments, the maximum value in the multiple set may be associated with at least one of a communication service type corresponding to the information bit sequence or a hardware resource limitation. In other words, a specific upper bound of the lifting factor may not be set, but the maximum value (that is, a proper lifting factor) in the multiple set is selected based on a system resource, an application scenario (for example, a high throughput type or a URLLC type), a hardware capability (for example, a maximum lifting factor and parallelism supported by a hardware device), and the like. In some embodiments, the maximum value in the multiple set may be specified as a very large number, to indicate an upper system limit. In some embodiments, the maximum value in the multiple set corresponding to each prime number or index may not be stored, but only a minimum value in the multiple set and a value feature (for example, the foregoing consecutive integers, and a linear piecewise function) that a multiple in the multiple set satisfies are stored. In this manner, a case in which a maximum coding length in 6G may be further expanded may be adapted.

The following describes an implementation of the prime number set according to an embodiment of the present disclosure. First, minimum and maximum values in the prime number set are described. In some embodiments, the minimum value in the prime number set may be associated with at least one of the following: a quantity of columns in a core part of the base matrix, or a connection relationship between the columns. The core part includes an information column and a core check column of the base matrix. In some embodiments, the columns in the core part of the base matrix are grouped, and two columns that are grouped in a same group satisfy a quasi-orthogonal condition. That is, associated nodes of the two columns intersect in at most one element. If there are more columns in a same group, any two columns in these columns satisfy the quasi-orthogonal condition. In this manner, there may be a plurality of results for grouping the columns of the core part of the base matrix. In some embodiments, the minimum value in the prime number set may be selected, so that the minimum value is greater than or equal to a minimum quantity of groups in a grouping manner.

In some embodiments, the minimum value in the prime number set may be associated with at least one of the following: a quantity of rows in a core part of the base matrix, or a connection relationship between the rows. In some embodiments, the rows in the core part of the base matrix are grouped, and two rows that are grouped in a same group satisfy a quasi-orthogonal condition. That is, associated nodes of the two rows intersect in at most one element. If there are more rows in a same group, any two rows in these rows satisfy the quasi-orthogonal condition. In this manner, there may be a plurality of results for grouping the rows of the core part of the base matrix. In some embodiments, the minimum value in the prime number set may be selected, so that the minimum value is greater than or equal to a minimum quantity of groups in a grouping manner.

It should be understood that the minimum value in the prime number set may alternatively be determined based on grouping of rows and columns in the core part of the base matrix. For example, the minimum value in the prime number set is selected, so that the minimum value is greater than or equal to a minimum quantity of groups in a grouping manner of rows and is greater than or equal to a minimum quantity of groups in a grouping manner of columns.

In some embodiments, minimum values in different prime number sets may be determined based on different scales of the base matrix. For example, for a small-scale base matrix (for example, a quantity of rows and/or columns satisfies a first condition), a minimum value in a prime number set may be greater than or equal to 7. For example, the first condition may include a matrix in which a quantity of information columns is 6 or 7 or a quantity of columns of a core part is less than 10. For a medium-scale base matrix (for example, a quantity of rows and/or columns satisfies a second condition), a minimum value in a prime number set may be greater than or equal to 11. For example, the second condition may include a matrix in which a quantity of information columns is 10 or a quantity of columns of a core part is less than 15, for example, a matrix scale of a BG2. For a large-scale base matrix (for example, a quantity of rows and/or columns satisfies a third condition), a minimum value in a prime number set may be greater than or equal to 23. For example, the third condition may include a matrix in which a quantity of information columns is greater than or equal to 20 or a quantity of columns of a core part is less than or equal to 30, for example, a matrix scale of a BG1.

In some embodiments, maximum values in different prime number sets may be determined based on different scales of the base matrix. For example, for a small-scale base matrix, a maximum value in a prime number set may be less than or equal to 53. For example, for a medium-scale base matrix, a maximum value in a prime number set may be greater than or equal to 57. For example, for a large-scale base matrix, a maximum value in a prime number set may be greater than or equal to 59.

The following describes a value feature of the prime number set. In some embodiments, the prime number set may include consecutive prime numbers, for example, consecutive prime numbers starting from the foregoing determined minimum value in the prime number set. Assuming that the minimum value is 11, the prime number set may include {11, 13, 17, 19, 23}.

In some embodiments, the prime number set may include consecutive prime numbers in a range. For example, the prime number set may include prime numbers ranging from 10 to 20, that is, {11, 13, 17, 19}.

In some embodiments, the prime number set may include non-consecutive prime numbers with an interval greater than a predetermined value. It should be understood that the predetermined value may be any proper positive integer. For example, if the predetermined value is 6, the prime number set may include {11, 17, 23}.

In some embodiments, the prime number set may include non-consecutive prime numbers, in a range, with an interval greater than a predetermined value. For example, the prime number set may include prime numbers, ranging from 10 to 50, with an interval greater than 3, that is, {11, 17, 23, 29, 37, 41, 47}.

So far, implementations of the prime number set and the multiple set that are corresponding to the lifting factor set are described. In some embodiments, the lifting factor set may further include a non-prime number. In some embodiments, if the length of the information bit sequence is less than or equal to a threshold length, a non-prime number may be used. If the length of the information bit sequence is greater than or equal to the threshold length, a prime number may be used. In other words, a non-prime number may be used for short codes, and a prime number may be used for medium-to-long codes. In some embodiments, the non-prime number may include at least one of the following: 4, 6, 9, 15, 22, or 26. For example, 4 and 6 may be separately designed for short codes. 9 and 15 may be a lifting factor set for compatibility with 5G. 22 and 26 are twice the prime numbers 11 and 13, that is, are essentially designed based on prime numbers to support medium-to-long codes.

In the foregoing implementations of the prime number set and the multiple set, the obtained lifting factor set may have repeated elements. In other words, there may be a same lifting factor for different indexes or prime numbers. For example, for a case in which the index is 0, the prime number is 11, and the multiple is 13 and a case in which the index is 1, the prime number is 13, and the multiple is 11, the lifting factors are both 143. Therefore, this embodiment of the present disclosure provides a processing solution for repeated elements. The following describes this in detail.

In some embodiments, repeated elements may be allowed in the lifting factor set. That is, one lifting factor may correspond to a plurality of indexes or prime numbers. In some embodiments in which one lifting factor corresponds to a plurality of indexes, a sending device may determine the plurality of indexes corresponding to the lifting factor, select a minimum prime number from a plurality of prime numbers corresponding to these indexes, and then select an index corresponding to the minimum prime number. In some embodiments in which one same lifting factor corresponds to a plurality of (for example, two) prime numbers, the sending device may determine the plurality of prime numbers corresponding to the lifting factor, and select a minimum prime number from the plurality of prime numbers. Still in the foregoing example, the index 0, the prime number 11, and the multiple 13 may be selected. In this manner, under a condition that the lifting factor is fixed, a smaller value of the prime number indicates a better cycle property. This is conducive to more stable encoding and decoding performance.

In some embodiments, some elements in the multiple set may be deleted, so that there is no repeated element in the lifting factor set. In some embodiments, for a lifting factor set including a prime number and a multiple set (for example, the lifting factor set shown in FIG. 6A), it may be designed that a multiple set associated with a first prime number does not include a value of a second prime number that is less than the first prime number. In some embodiments, for a lifting factor set including an index, a prime number, and a multiple set (for example, the lifting factor set shown in FIG. 6B), it may be designed that a multiple set associated with a first index does not include a value of a prime number associated with a second index. The second index is less than the first index. In other words, a multiple set corresponding to an index i does not include a prime number corresponding to an index less than i. In some embodiments, for a lifting factor set including a set of values of lifting factors and a prime number set (for example, the lifting factor set shown in FIG. 6C), it is clearly that no repeated lifting factor is included.

According to embodiments of the present disclosure, the lifting factor set is designed based on the prime number and the multiple set in a non-exponential form. Therefore, a quantity of shortened bits does not increase exponentially with an increase of a coding length, to achieve more stable coding and decoding performance.

Correspondingly, an embodiment of the present disclosure provides a communication solution based on the foregoing lifting factor set. The following describes this with reference to FIG. 7. FIG. 7 is a diagram of a communication process 700 according to an embodiment of the present disclosure. It may be understood that the communication process shown in FIG. 7 is merely an example rather than a limitation. This embodiment of the present disclosure may include steps not shown in FIG. 7, or some steps shown in FIG. 7 are omitted. In addition, a sequence of steps in FIG. 7 is merely used for illustration, but is not used for limitation.

Unless otherwise specified in this application, the communication process 700 may be performed between a sending device and a receiving device in the communication system 100. The "sending device" or the "receiving device" may be the sending device or the receiving device, or may be an apparatus that can support the sending device or the receiving device in implementing the function, for example, a system on chip (system on chip, SoC) or a modem (modem). For convenience, the sending device and the receiving device are uniformly used for description in the following.

As shown in FIG. 7, in step 710, the sending device may determine a lifting factor from lifting factor sets based on a length of an information bit sequence and a base matrix. In some embodiments, the length of the information bit sequence may be a length of a to-be-encoded information bit sequence. In some embodiments, the length of the information bit sequence may be a length of an information bit sequence obtained by concatenated encoding. For example, the length of the information bit sequence may be a length of an information bit sequence including a cyclic redundancy check (cyclic redundancy check, CRC) bit.

As shown in FIG. 7, in step 711, the sending device first determines the lifting factor set.

In some embodiments, a lifting factor set may be separately stored for each base matrix (for example, a BG1 or a BG2). In this case, the sending device may determine a base matrix from a plurality of base matrices based on at least one of a length, a coding length, or a coding rate of the information bit sequence. The sending device may determine, based on the determined base matrix, a lifting factor set corresponding to the base matrix.

In some embodiments, one base matrix may correspond to one lifting factor set. In some embodiments, one base matrix may correspond to two or more lifting factor sets. In some embodiments, one lifting factor set may correspond to two or more base matrices.

In some embodiments, different lifting factor sets may be used for different communication service types. In this case, the sending device may determine a communication service type corresponding to the information bit sequence. Based on the communication service type, the sending device may determine the lifting factor set corresponding to the communication service type. In some embodiments, the communication service type may include an eMBB type, an mMTC type, a URLLC type, or a high throughput type. It should be understood that any other suitable type known or developed in the future is also feasible.

In the context of the present disclosure, the high throughput type may also be referred to as an extremely high coding rate type. For example, the high throughput type may include a communication service scenario with a coding rate greater than or equal to 0.917. In another example, the high throughput type includes a communication service scenario with a coding rate higher than 0.926. In still another example, the high throughput type includes a communication service scenario with a high requirement for a communication rate, such as a communication service scenario with a peak throughput higher than 100 Gbps or 150 Gbps.

In some embodiments, different lifting factor sets and different base matrices may be used for different communication service types. For example, the BG1 and the BG2 may be used in the eMBB type, and a 5G lifting factor set shown in FIG. 4 is used. In the high throughput type, a core region (for example, rows 1 to 4 and columns 1 to 26, or rows 1 to 5 and columns 1 to 27) of the BG1 may be used as the base matrix, or an additional information column is added based on the BG1 to generate the base matrix. In addition, in the high throughput type, a lifting factor set 1 in this solution may be used. In the URLLC type (also referred to as an ultra-low coding rate type), a low rate region (for example, a check matrix region corresponding to a check row greater than or equal to 12, 22, 32, or 42) of the BG2 may be used as the base matrix, or an additional check row is added based on the BG2 to generate the base matrix. In addition, in the URLLC type, a lifting factor set 2 in this solution may be used. The lifting factor set 1 and the lifting factor set 2 may correspond to different quantities of indexes, different prime number sets, and/or different multiple sets.

In some alternative embodiments, the BG1 and the BG2 may be used in the eMBB type, and the lifting factor set 1 and the lifting factor set 2 in the foregoing solution are respectively used for the BG1 and the BG2. In the high throughput type, the core region (for example, rows 1 to 4 and columns 1 to 26, or rows 1 to 5 and columns 1 to 27) of the BG1 may be used as the base matrix, or an additional information column is added based on the BG1 to generate the base matrix. In addition, in the high throughput type, the lifting factor set 1 in this solution or a subset thereof may be used. In the URLLC type, the low rate region (for example, a check matrix region corresponding to a check row greater than or equal to 12, 22, 32, or 42) of the BG2 may be used as the base matrix, or an additional check row is added based on the BG2 to generate the base matrix. In addition, in the URLLC type, the lifting factor set 2 in this solution or a subset thereof may be used.

In some alternative embodiments, the BG1 and the BG2 may be used in the eMBB type, and a 5G lifting factor set shown in FIG. 4 is used. In the high throughput type, a newly added base matrix BG3 and the lifting factor set 1 in this solution may be used. The BG3 may be stored in association with the lifting factor set 1 in this solution. In the URLLC type, a newly added base matrix BG4 and the lifting factor set 2 in this solution may be used. The BG4 may be stored in association with the lifting factor set 2 in this solution.

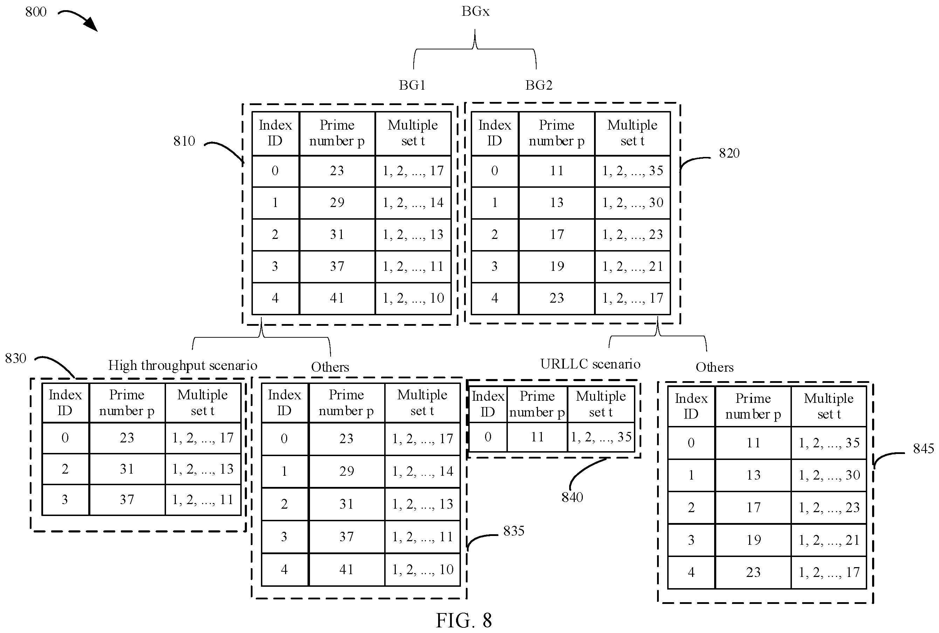

For ease of understanding, the following describes a process of determining the lifting factor set with reference to FIG. 8. FIG. 8 is a diagram 800 of an example process of determining the lifting factor set according to an embodiment of the present disclosure. In this example, for eMBB or another communication service type, the BG1 and the BG2 are used, and the lifting factor set 1 and the lifting factor set 2 in this solution are correspondingly used. For the high throughput type, the core region of the BG1 is used as the base matrix or an additional information column is added based on the BG1 to generate the base matrix, and the lifting factor set 1 in this solution or a subset thereof is used. For the URLLC type, the low rate region of the BG2 is used as the base matrix or an additional check row is added based on the BG2 to generate the base matrix, and the lifting factor set 2 in this solution or a subset thereof is used.

As shown in FIG. 8, reference numerals 810 and 820 respectively indicate the lifting factor set 1 and the lifting factor set 2. It can be learned that in this example, the lifting factor set 1 and the lifting factor set 2 correspond to different prime number sets and different multiple sets. The lifting factors for the BG1 and the BG2 are different. For example, the BG2 may support medium and low coding rates of medium and short codes, and the BG1 may support medium and high coding rates of medium and long codes. As shown in FIG. 8, in some embodiments, a minimum prime number of the lifting factor set 1 may be greater than a minimum prime number of the lifting factor set 2. In this manner, a larger matrix size and lower orthogonality of the BG1 may be compatible.

Although FIG. 8 shows that a quantity of indexes of the lifting factor set 1 is equal to a quantity of indexes of the lifting factor set 2, this embodiment of the present disclosure is not limited thereto. In some embodiments, the quantity of indexes of the lifting factor set 1 may be greater than the quantity of indexes of the lifting factor set 2. Therefore, a proper fine granularity may be designed based on a quantity of information columns. A larger matrix size requires a larger quantity of indexes to support fine-granularity performance. In some embodiments, the quantity of indexes of the lifting factor set 1 may be less than the quantity of indexes of the lifting factor set 2. This is because the BG2 can support extremely short codes, and therefore some additional indexes for the case of extremely short codes are set.

In some embodiments, a lifting factor set may be selected based on a scenario requirement by selecting an index ID. As shown in FIG. 8, for the high throughput type, a subset corresponding to ID=0, 2, or 3 or a smaller prime number may be selected from the lifting factor set 1, as shown by a reference numeral 830. In this manner, shifting values corresponding to some IDs can be set to facilitate hardware implementation and highly parallel decoding, and a lifting factor set corresponding to these IDs is selected. For eMBB or another communication service type, the lifting factor set 1 is used, as shown by a reference numeral 835.

Still refer to FIG. 8. For the URLLC type, a subset corresponding to ID=0 or a minimum prime number may be selected from the lifting factor set 2, as shown by a reference numeral 840. In this way, a lifting factor set with a better cycle structure can be selected, to satisfy a requirement of an ultra-reliable and an error floor (error floor)-free scenario. For eMBB or another communication service type, the lifting factor set 2 is used, as shown by a reference numeral 845.

In some alternative or additional embodiments, the selection of the lifting factor set based on the scenario requirement may be implemented by selecting a maximum value or a minimum value of a multiple set corresponding to each index ID. This is because code lengths for the scenarios are different. For example, a code length in the URLLC type is usually short, and a very large lifting factor does not need to be supported. A code length in the high throughput type is long, and does not need to be compatible with a very small lifting factor. In this way, scenario requirements can be better met.

In some alternative or additional embodiments, when a lifting factor set is selected according to a scenario requirement, the selection may not be performed based on an index ID, but only a part of available lifting factors are specified. These lifting factors may be a proper subset of all supported lifting factors. In this case, some prime numbers and multiple sets do not appear in a lifting factor set selected for a specific scenario.

Refer to FIG. 7. In step 712, the sending device may determine a set of all information columns (also referred to as an information column set below for convenience) supported by the base matrix in a current scenario. In some embodiments, the sending device may determine the information column set based on at least one of the base matrix, the coding length or the coding rate of the information bit sequence. In some embodiments, for the BG1, if the length of the information bit sequence is less than 2530 or the coding rate of the information bit sequence is greater than 0.917 (that is, the high throughput type), the information column set may be determined as {22, 24, 26}. Then, the sending device may select a quantity of to-be-used information columns from the information column set based on the length of the information bit sequence.

In step 713, the sending device may determine an expected value of the lifting factor according to the length of the information bit sequence and the selected quantity of information columns of the base matrix, and select, from the lifting factor set, a value close to the expected value as the lifting factor. In some embodiments, a value closest to the expected value may be selected as the lifting factor. In some embodiments, any value whose difference from the expected value is less than a threshold may be selected as the lifting factor. It should be understood that the lifting factor may be determined from the lifting factor set in any other proper manner. This is not limited in this embodiment of the present disclosure.

According to this embodiment of the present disclosure, both the quantity of information columns and the lifting factor can be determined based on the determined information column set and the lifting factor set. In this way, a quantity of shortened bits can be further reduced, integrity of a base graph can be maintained, and requirements in different scenarios can be met.

In some embodiments, the maximum value of the lifting factor (namely, $Z_{max}$) may not be set or $Z_{max}$ is specified as a very large number. In these cases, a quantity of lifting factors supported by the lifting factor set is infinite or very large. Therefore, embodiments of the present disclosure further provide a rate matching solution, to improve rate matching performance in this case. Certainly, this solution may also be used in other cases. In this solution, the sending device may determine, based on at least one of the coding length of the information bit sequence or the information column length of the base matrix, a minimum multiple corresponding to each prime number in the prime number set. The sending device may determine a lifting factor based on a minimum value in products of all the prime numbers and the corresponding minimum multiples. For example, based on a length K of a to-be-sent information bit sequence and a length kb of an information column of a to-be-used check matrix, a minimum multiple t that satisfies $kb \times p \times t \geq K$ may be calculated for each index ID or each prime number. Then, a lifting factor Z may be selected as minimum $p \times t$ corresponding to all index IDs or all prime numbers. In some embodiments in which $Z_{max}$ is not set, the selected lifting factor Z is used. In some embodiments in which $Z_{max}$ is specified, if the selected $Z \leq Z_{max}$, the selected lifting factor Z is used. Otherwise, $Z_{max}$ is used.

In some embodiments, the lifting factor set may include a prime number set and a set of values of lifting factors, as shown in FIG. 6C. In this case, a value of one lifting factor may correspond to a plurality of (for example, two) prime numbers. Accordingly, embodiments of the present disclosure further provide a rate matching solution, to improve rate matching performance in this case. Certainly, this solution may also be used in other cases. In this solution, the sending device may select a minimum lifting factor Zc in the lifting factor set based on the length K of the to-be-sent information bit sequence and the length kb of the information column of the to-be-used check matrix, so that $kb \times Zc \geq K$. In addition, a minimum prime number that satisfies $p|Zc$ in the prime number set is selected. Therefore, a manner in which the prime number in the prime number set corresponds to the lifting factor may be specified, and the minimum prime number may be selected.

Still refer to FIG. 7. In step 714, the sending device may determine a check matrix based on the determined lifting factor and the base matrix, to encode the information bit sequence. In some embodiments, the sending device may determine the shifting value set for a non-zero position in the base matrix based on the determined lifting factor. The sending device may obtain the check matrix based on the shifting value set and the base matrix. Then, the sending device may encode the information bit sequence based on the check matrix, to obtain an encoded information bit sequence. It should be noted herein that the operation of determining the shifting value set based on the lifting factor may be implemented based on any known or future-developed manner. This is not limited in this embodiment of the present disclosure.

Still refer to FIG. 7. In step 720, the sending device may send the encoded information bit sequence to the receiving device. In some embodiments, the sending device may further send at least one of the following information to the receiving device: the length of the information bit sequence, a length (that is, a coding length) of the encoded information bit sequence, the base matrix, or the lifting factor set. Therefore, a decoding operation of the receiving device can be facilitated. Correspondingly, the receiving device may receive the encoded information bit sequence.

As shown in FIG. 7, in step 730, the receiving device may determine the check matrix, to decode the information bit sequence. A process of determining the check matrix is similar to the process described with reference to step 710, and details are not described herein again.

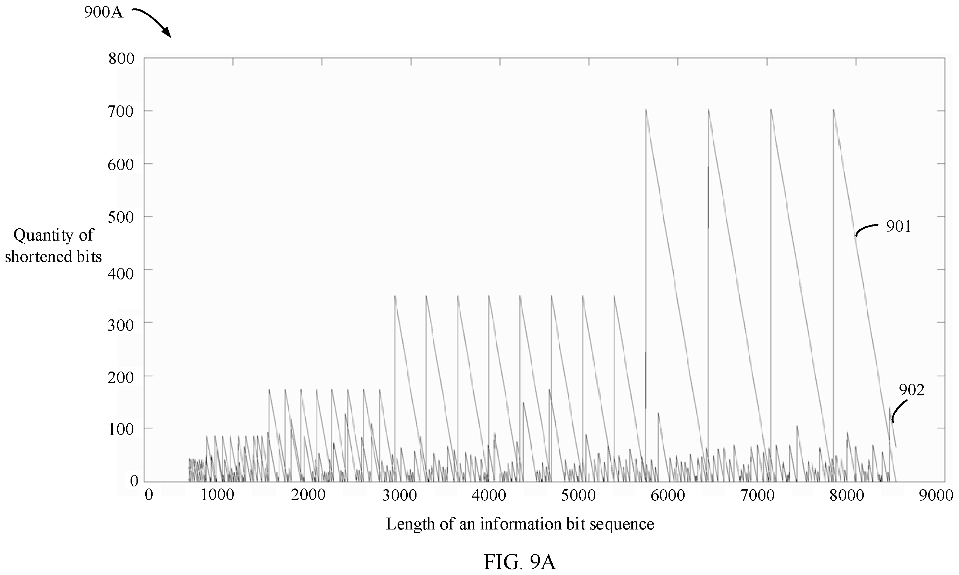

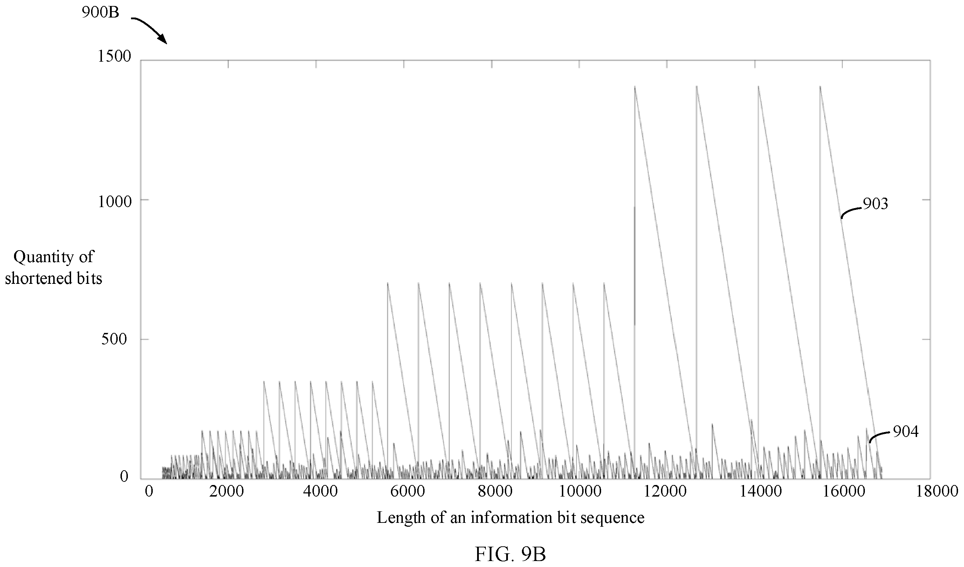

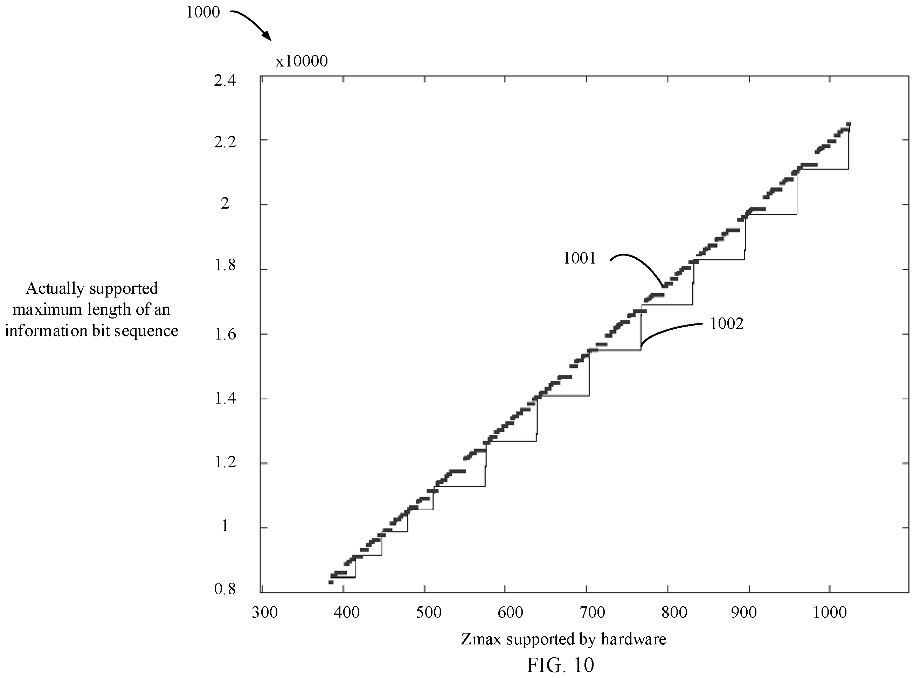

At this point, a communication solution according to embodiments of the present disclosure is described. In this solution, the lifting factor set based on the prime number and the multiple set in the non-exponential form is designed, so that a quantity of to-be-shortened bits does not increase exponentially with an increase of a coding length. Therefore, more stable encoding and decoding performance can be achieved. The following provides detailed descriptions with reference to FIG. 9A, FIG. 9B, and FIG. 10.

FIG. 9A is a diagram of a simulation result 900A of a quantity of shortened bits varying with a length of an information bit sequence according to an embodiment of the present disclosure. The simulation result 900A is obtained by performing simulation for a length range of a 5G information bit sequence. A reference numeral 901 indicates a case of using a lifting factor set in the conventional solution shown in FIG. 4, and a reference numeral 902 indicates a case of using the lifting factor set according to an embodiment of the present disclosure. It can be learned that, for the length range of the 5G information bit sequence, a quantity of bits shortened due to the lifting factor set in the conventional solution increases exponentially with the length of the information bit sequence. In comparison, a quantity of bits shortened due to the lifting factor set in this solution does not increase with an increase of the length of the information bit sequence, but remains in a very stable range. Therefore, according to this solution, for the length range of the 5G information bit sequence, integrity of a base graph and more stable encoding and decoding performance can be ensured.

FIG. 9B is a diagram of another simulation result 900B of a quantity of shortened bits varying with a length of an information bit sequence according to an embodiment of the present disclosure. The simulation result 900B is obtained by performing simulation for a larger length range of a 6G information bit sequence. A reference numeral 903 indicates a case of using a lifting factor set in the conventional solution shown in FIG. 4, and a reference numeral 904 indicates a case of using the lifting factor set according to an embodiment of the present disclosure. It can be learned that, for the larger length range of the information bit sequence, a quantity of bits shortened due to the lifting factor set in the conventional solution also increases exponentially with the length of the information bit sequence. In comparison, a quantity of bits shortened due to the lifting factor set in this solution does not increase with an increase of the length of the information bit sequence, but remains in a very stable range. Therefore, according to this solution, for a larger length range of the information bit sequence, integrity of a base graph and more stable encoding and decoding performance can also be ensured.

FIG. 10 is a diagram of a simulation result 1000 of a relationship between a maximum value of a lifting factor supported by hardware and an actually supported maximum length of an information bit sequence according to an embodiment of the present disclosure. As shown in FIG. 10, a reference numeral 1001 indicates a case in which a lifting factor set according to an embodiment of the present disclosure is based on a linear multiple. The reference number 1002 shows a case in which a lifting factor set in the conventional solution is based on an integer multiple of a power of 2. It can be learned that, in a case in which the lifting factor set in the conventional solution is used, as a maximum value of a lifting factor supported by hardware increases (that is, as parallelism and computational power supported by hardware increase), an actually supported maximum length of the information bit sequence increases stepwise. In comparison, in a case in which the lifting factor set according to this embodiment of the present disclosure is used, as a maximum value of a lifting factor supported by hardware increases (that is, as parallelism and computational power supported by hardware increase), an actually supported maximum length of the information bit sequence increases approximately linearly. Therefore, according to this solution, higher hardware utilization can be implemented, and computational power of a terminal has a finer granularity.

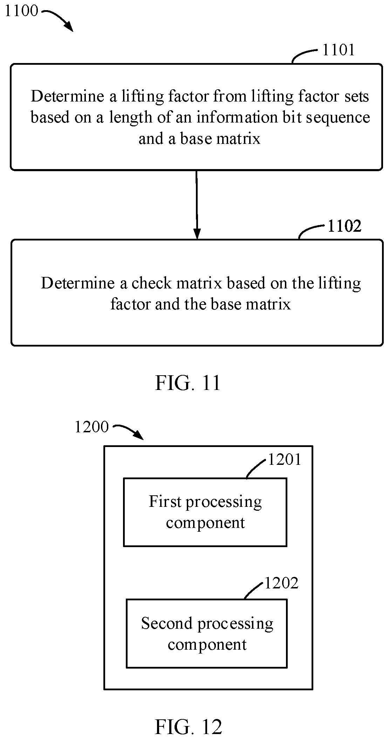

Corresponding to the foregoing communication process, an embodiment of the present disclosure further provides a communication method that may be implemented at a communication device (that is, a sending device and/or a receiving device). FIG. 11 is a schematic flowchart of a communication method 1100 according to an embodiment of the present disclosure. For example, the method 1100 may be implemented at the terminal 120, the RAN node 110, the core network device, or the server shown in FIG. 1. It should be understood that the method 1100 may include other additional steps that are not shown, or some of the shown steps may be omitted. The scope of the present disclosure is not limited thereto.

In step 1101, a communication device may determine a lifting factor from lifting factor sets based on a length of an information bit sequence and a base matrix. In some embodiments, the lifting factor set may include a prime number and a multiple set associated with the prime number. In some embodiments, the lifting factor set may further include an index associated with the prime number. In some embodiments, the lifting factor set may include a plurality of lifting factors, and a lifting factor in the plurality of lifting factors is a product of the prime number and a multiple in the multiple set associated with the prime number. In some embodiments, a multiple in the multiple set may be a positive integer, and the multiple set may include a value not equal to $A^x$, where A is a positive integer greater than or equal to 2, and x is a nonnegative integer. Therefore, the lifting factor set based on the prime number and the multiple set in a non-exponential form can be specified, so that a quantity of shortened bits does not increase exponentially with an increase of a coding length, to achieve more stable encoding and decoding performance.

In some embodiments, the lifting factor set may further include a non-prime number. In some embodiments, the non-prime number may include at least one of the following: 4, 6, 9, 15, 22, or 26. Therefore, different coding lengths can be better supported by combining a non-prime number and a prime number.

In some embodiments, the multiple set may include at least one of the following: consecutive integers spaced by a predetermined interval; an integer set satisfying a piecewise linear function; a range of multiples; or a number that is not selected as the multiple in the range. Therefore, a manner of obtaining a value of an element in the multiple set corresponding to the lifting factor set can be specified.

In some embodiments, the maximum value in the multiple set may be determined based on a maximum value of the lifting factor and the prime number. In some embodiments, the maximum value in the multiple set may be determined based on a maximum length of an information bit sequence, a quantity of information columns of the base matrix corresponding to the maximum length, and the prime number. In some embodiments, the maximum value in the multiple set may be associated with at least one of: a communication service type corresponding to the information bit sequence, or a hardware resource limitation. Therefore, the maximum value in the multiple set can be specified.

In some embodiments, a minimum value in the plurality of prime numbers corresponding to the plurality of lifting factor sets may be associated with at least one of the following: a quantity of columns in a core part of the base matrix, where the core part includes an information column and a core check column of the base matrix; a connection relationship between the columns in the core part of the base matrix; a quantity of rows in the core part of the base matrix; or a connection relationship between the rows in the core part of the base matrix. In some embodiments, the connection relationship between the columns in the core part of the base matrix may include: Two columns grouped in a same group satisfy a quasi-orthogonal condition. In some embodiments, the connection relationship between the rows in the core part of the base matrix may include: Two rows grouped in a same group satisfy a quasi-orthogonal condition. Therefore, the minimum value in the prime number set corresponding to the lifting factor set can be specified.

In some embodiments, the plurality of prime numbers corresponding to the plurality of lifting factor sets include at least one of the following: consecutive prime numbers; or non-consecutive prime numbers with an interval greater than a predetermined value. In some embodiments, the consecutive prime numbers include {11, 13, 17, 19, 23}; or the non-consecutive prime numbers with the interval greater than the predetermined value include {11, 17, 23}. Therefore, a manner of obtaining a value of an element in the prime number set can be specified.

In some embodiments, a multiple set associated with a first index does not include a value of a prime number associated with a second index, and the second index is less than the first index; or a multiple set associated with a first prime number does not include a value of a second prime number, and the second prime number is less than the first prime number. Therefore, there may be no repeated element between the plurality of lifting factor sets.

In some embodiments, the communication device may determine two prime numbers corresponding to the lifting factor, and select a minimum prime number from the two prime numbers. In some embodiments, the communication device may determine a plurality of indexes corresponding to the lifting factor, and select an index corresponding to a minimum prime number in a plurality of prime numbers corresponding to the plurality of indexes. Therefore, a good cycle property can be ensured, and more stable encoding and decoding performance can be achieved.

In some embodiments, a base matrix in a plurality of base matrices corresponds to a lifting factor set in the plurality of lifting factor sets. The communication device may determine, based on at least one of the length, a coding length, or a coding rate of the information bit sequence, the base matrix from the plurality of base matrices, and determine, based on the base matrix, the lifting factor set corresponding to the base matrix. Therefore, an appropriate base matrix and an appropriate lifting factor set can be selected according to a usage scenario, to satisfy requirements of different scenarios.

In some embodiments, the communication device may determine, based on a communication service type corresponding to the information bit sequence, the lifting factor set corresponding to the communication service type. In some embodiments, the communication service type may include an eMBB type, a URLLC type, or a high throughput type. In some embodiments, if the communication service type is the high throughput type, the communication device may determine that the prime number corresponding to the lifting factor set includes 23, 31, or 37. In some embodiments, if the communication service type is the URLLC type, the communication device may determine that the prime number corresponding to the lifting factor set includes 11. Therefore, the lifting factor set can be selected based on a scenario, to better satisfy a scenario requirement.

In some embodiments, the communication device may determine, based on at least one of the coding length of the information bit sequence or an information column length of the base matrix, a minimum multiple corresponding to each prime number in the plurality of prime numbers corresponding to the plurality of lifting factor sets; and determine the lifting factor based on a minimum value in products of all the prime numbers and the corresponding minimum multiples. Therefore, for a case in which the maximum value of the lifting factor is not specified or the maximum value of the lifting factor is set to a very large number, an appropriate lifting factor can be determined, to implement rate matching.

In step 1102, the communication device may determine a check matrix based on the lifting factor and the base matrix, where the check matrix is used to encode or decode the information bit sequence.

According to the method 1100, encoding or decoding may be performed based on the lifting factor set that is based on both the prime number and the multiple set in the non-exponential form. Therefore, a quantity of shortened bits does not increase exponentially with an increase of a coding length, to achieve more stable coding and decoding performance.

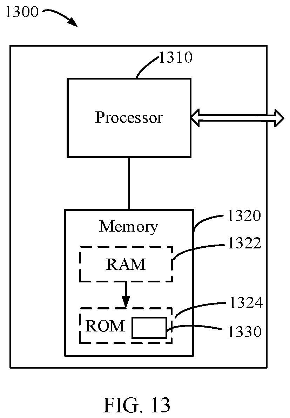

Corresponding to the foregoing communication method, embodiments of the present disclosure further provide a communication apparatus and a communication device. The following provides descriptions with reference to FIG. 12 and FIG. 13. FIG. 12 is a block diagram of a communication apparatus 1200 according to an embodiment of the present disclosure. The communication apparatus 1200 may be implemented at a communication device (for example, a sending device and/or a receiving device). The communication apparatus 1200 may be a part of the sending device or the receiving device, or may be the sending device or the receiving device. It should be understood that the communication apparatus 1200 may include more additional components than the shown components, or some shown components are omitted. This is not limited in this embodiment of the present disclosure.

As shown in FIG. 12, the communication apparatus 1200 may include a first processing component 1201 and a second processing component 1202. The first processing component 1201 may be configured to determine a lifting factor from lifting factor sets based on a length of an information bit sequence and a base matrix. The second processing component 1202 may be configured to determine a check matrix based on the lifting factor and the base matrix, where the check matrix is used to encode or decode the information bit sequence.

In some embodiments, the lifting factor set may include a prime number and a multiple set associated with the prime number. In some embodiments, the lifting factor set may further include an index associated with the prime number. In some embodiments, the lifting factor set may include a plurality of lifting factors, and a lifting factor in the plurality of lifting factors is a product of the prime number and a multiple in the multiple set associated with the prime number. In some embodiments, a multiple in the multiple set may be a positive integer, and the multiple set may include a value not equal to $A^x$, where A is a positive integer greater than or equal to 2, and x is a nonnegative integer.

In some embodiments, the lifting factor set may further include a non-prime number. In some embodiments, the non-prime number may include at least one of the following: 4, 6, 9, 15, 22, or 26.

In some embodiments, the multiple set may include at least one of the following: consecutive integers spaced by a predetermined interval; an integer set satisfying a piecewise linear function; a range of multiples; or a number that is not selected as the multiple in the range. Therefore, a manner of obtaining a value of an element in the multiple set corresponding to the lifting factor set can be specified.

In some embodiments, the maximum value in the multiple set may be determined based on a maximum value of the lifting factor and the prime number. In some embodiments, the maximum value in the multiple set may be determined based on a maximum length of an information bit sequence, a quantity of information columns of the base matrix corresponding to the maximum length, and the prime number. In some embodiments, the maximum value in the multiple set may be associated with at least one of: a communication service type corresponding to the information bit sequence, or a hardware resource limitation. Therefore, the maximum value in the multiple set can be specified.

In some embodiments, a minimum value in the plurality of prime numbers corresponding to the plurality of lifting factor sets may be associated with at least one of the following: a quantity of columns in a core part of the base matrix, where the core part includes an information column and a core check column of the base matrix; a connection relationship between the columns in the core part of the base matrix; a quantity of rows in the core part of the base matrix; or a connection relationship between the rows in the core part of the base matrix. In some embodiments, the connection relationship between the columns in the core part of the base matrix may include: Two columns grouped in a same group satisfy a quasi-orthogonal condition. In some embodiments, the connection relationship between the rows in the core part of the base matrix may include: Two rows grouped in a same group satisfy a quasi-orthogonal condition. Therefore, the minimum value in the prime number set corresponding to the lifting factor set can be specified.

In some embodiments, the plurality of prime numbers corresponding to the plurality of lifting factor sets include at least one of the following: consecutive prime numbers; or non-consecutive prime numbers with an interval greater than a predetermined value. In some embodiments, the consecutive prime numbers include {11, 13, 17, 19, 23}; or the non-consecutive prime numbers with the interval greater than the predetermined value include {11, 17, 23}. Therefore, a manner of obtaining a value of an element in the prime number set can be specified.

In some embodiments, a multiple set associated with a first index does not include a value of a prime number associated with a second index, and the second index is less than the first index; or a multiple set associated with a first prime number does not include a value of a second prime number, and the second prime number is less than the first prime number. Therefore, there may be no repeated element between the plurality of lifting factor sets.

In some embodiments, the communication apparatus 1200 may further include a third processing component and a fourth processing component. The third processing component may be configured to determine the base matrix from a plurality of base matrices based on at least one of the length, a coding length, or a coding rate of the information bit sequence, where a base matrix in the plurality of base matrices corresponds to a lifting factor set in a plurality of lifting factor sets. The fourth processing component may be configured to determine, based on the base matrix, the lifting factor set corresponding to the base matrix.

In some embodiments, the first processing component 1201 may include: a component, configured to determine, based on at least one of the coding length of the information bit sequence or an information column length of the base matrix, a minimum multiple corresponding to each prime number in the plurality of prime numbers corresponding to the plurality of lifting factor sets; and a component, configured to determine the lifting factor based on a minimum value in products of all the prime numbers and the corresponding minimum multiples.

In some embodiments, the communication apparatus 1200 may further include a fifth processing component. The fifth processing component may be configured to determine, based on a communication service type corresponding to the information bit sequence, the lifting factor set corresponding to the communication service type. In some embodiments, the communication service type may include an eMBB type, a URLLC type, or a high throughput type. In some embodiments, the fifth processing component may further include: a component, configured to: if the communication service type is the high throughput type, determine that the prime number corresponding to the lifting factor set includes 23, 31, or 37; or a component, configured to: if the communication service type is the URLLC type, determine that the prime number corresponding to the lifting factor set includes 11.

In some embodiments, the communication apparatus 1200 may further include a sixth processing component and a seventh processing component. The sixth processing component may be configured to determine two prime numbers corresponding to the lifting factor. The seventh processing component may be configured to select a minimum prime number from the two prime numbers.

In some embodiments, the communication apparatus 1200 may further include an eighth processing component and a ninth processing component. The eighth processing component may be configured to determine that the lifting factor corresponds to a plurality of indexes. The ninth processing component may be configured to select an index corresponding to a minimum prime number in a plurality of prime numbers corresponding to the plurality of indexes.

Therefore, a communication apparatus that performs encoding or decoding based on the lifting factor set that is based on both the prime number and the multiple set in a non-exponential form can be implemented. Therefore, a quantity of shortened bits does not increase exponentially with an increase of a coding length, to achieve more stable coding and decoding performance.

FIG. 13 is a simplified block diagram of a communication device 1300 suitable for implementing embodiments of the present disclosure. The device 1300 may be provided to implement a transmitting device or a receiving device or a communication device that includes a transmitting function and a receiving function. As shown in the figure, the device 1300 includes one or more processors 1310 and one or more memories 1320 coupled to the one or more processors 1310. Optionally, the one or more memories 1120 may be integrated with the one or more processors 1110.

The processor 1310 may be of any type suitable for a native technology network, and as a limiting example, may include one or more of the following: a general-purpose computer, a dedicated computer, a microprocessor, a digital signal processor, and a processor that is based on a multi-core processor architecture. The device 1300 may have a plurality of processors, such as an application-specific integrated circuit chip, which in terms of time, belongs to a clock synchronized with a main processor.

The memory 1320 may include one or more non-volatile memories and one or more volatile memories. An example of the non-volatile memory includes but is not limited to a read-only memory (read-only memory, ROM) 1324, an electrically programmable read-only memory (electrically programmable read-only memory, EPROM), a flash memory, a hard disk drive, a compact disc (compact disc, CD), a digital video disk (digital video disk, DVD), and another magnetic storage and/or optical storage apparatus. An example of the volatile memory includes but is not limited to a random access memory (random access memory, RAM) 1322 and another volatile memory that does not persist in power-off duration.

A computer program 1330 includes computer-executable instructions performed by an associated processor 1310. The program 1330 may be stored in the ROM 1320. The processor 1310 may perform any proper action and processing by loading the program 1330 into the RAM 1320.

Embodiments of the present disclosure may be implemented by using the program 1330, so that the device 1300 performs the processing in the present disclosure as discussed with reference to FIG. 6 to FIG. 11. The device 1300 may correspond to the communication apparatus 1200, and a functional module in the communication apparatus 1200 is implemented by using software of the device 1300. In other words, the functional module included in the communication apparatus 1200 is generated after the processor 1310 of the device 1300 reads program code stored in the memory 1320. Embodiments of the present disclosure may alternatively be implemented by hardware or a combination of software and hardware.

In some embodiments, the program 1330 may be tangibly included in a computer-readable medium, and the computer-readable medium may be included in the device 1300 (for example, in the memory 1320) or another storage device that can be accessed by the device 1300. The program 1330 may be loaded from the computer-readable medium to the RAM 1322 for execution. The computer-readable medium may include any type of tangible non-volatile memory, for example, a ROM, an EPROM, a flash memory, a hard disk drive, a CD, or a DVD.

In some embodiments, the device 1300 may further include one or more communication modules (not shown). The one or more communication modules may be coupled to the processor 1310. The one or more communication modules may be configured for bidirectional communication. The one or more communication modules may have a communication interface to facilitate communication. The communication interface may represent any interface necessary to communicate with another network element.

In general, the various example embodiments of the present disclosure may be implemented in hardware or dedicated circuits, software, logic, or any combination thereof. Some aspects may be implemented in hardware, while other aspects may be implemented in firmware or software that may be executed by a controller, a microprocessor, or another compute device. When various aspects of the embodiments of the present disclosure are illustrated or described as block diagrams, flowcharts, or using some other graphical representation, it is appreciated that the blocks, apparatuses, systems, technologies, or methods described herein may be implemented as non-restrictive examples in hardware, software, firmware, dedicated circuits or logic, general-purpose hardware or controllers, or other compute devices, or some combination thereof. An example of a hardware device that may be used to implement embodiments of the present disclosure includes but is not limited to a field programmable gate array (field programmable gate array, FPGA), an application-specific integrated circuit (application-specific integrated circuit, ASIC), an application-specific standard part (application-specific standard part, ASSP), a system on chip (system on chip, SOC), a complex programmable logic device (complex programmable logic device, CPLD), and the like.

In an example, embodiments of the present disclosure may be described in the context of machine-executable instructions. For example, the machine-executable instructions are included in a program module executed in a device on a target real or virtual processor. Usually, the program module includes a routine, a program, a library, an object, a class, a component, a data structure, and the like, and executes a specific task or implements a specific abstract data structure. In various embodiments, the functions of the program modules may be combined or split between the described program modules. The machine-executable instructions for the program module may be executed locally or within a distributed device. In the distributed device, the program module may be located in both a local storage medium and a remote storage medium.

Computer program code for implementing the method disclosed in the present disclosure may be written in one or more programming languages. The computer program code may be provided for a processor of a general-purpose computer, a dedicated computer, or another programmable data processing apparatus, so that when the program code is executed by the computer or the another programmable data processing apparatus, functions/operations specified in the flowcharts and/or block diagrams are implemented. The program code may be executed entirely on a computer, partly on a computer, as a standalone software package, partly on a computer and partly on a remote computer, or entirely on a remote computer or a server.

In the context of the present disclosure, the computer program code or related data may be carried in any proper carrier, so that the device, the apparatus, or the processor can perform various processing and operations described above. Examples of the carrier include a signal, a computer-readable medium, and the like. Examples of the signal may include an electrical signal, an optical signal, a radio signal, a voice signal, or other forms of propagated signals, such as a carrier wave and an infrared signal. The machine-readable medium may be any tangible medium that includes or stores programs for or with respect to an instruction execution system, apparatus, or device. The machine-readable medium may be a machine-readable signal medium or a machine-readable storage medium. The machine-readable medium may include but is not limited to an electronic, magnetic, optical, electromagnetic, infrared, or semiconductor system, apparatus, or device, or any appropriate combination thereof. A more detailed example of the machine-readable storage medium includes an electrical connection with one or more wires, a portable computer disk, a hard disk drive, a RAM, a ROM, an EPROM or flash memory, an optical storage device, a magnetic storage device, or any appropriate combination thereof.

In addition, although the operations are described in a particular order, this should not be understood as requiring the operations to be completed in the particular order shown or in a sequential order, or performing all of the illustrated operations to obtain a desired result. In some cases, multitasking or parallel processing is beneficial. Likewise, although the discussion above includes some specific implementation details, this should not be construed as a limitation on the scope of any invention or claim, but rather as a description of a specific embodiment that may be directed to a particular invention. Some features described in the context of separate embodiments in this specification may also be incorporated and implemented in a single embodiment. Conversely, various features described in the context of a single embodiment may also be implemented separately in a plurality of embodiments or in any suitable sub-combination.

Although the subject matter has been described in language specific to structural features and/or methodological actions, it should be understood that the subject matter defined in the appended claims is not limited to the specific features or actions described above. Rather, the specific features and actions described above are disclosed as example forms of implementing the claims.

**Claims**

1.  A communication method, comprising:

    determining a lifting factor from lifting factor sets based on a length of an information bit sequence and a base matrix, wherein the lifting factor set comprises a prime number and a multiple set associated with the prime number, or the lifting factor set comprises a plurality of lifting factors, a lifting factor in the plurality of lifting factors is a product of the prime number and a multiple in the multiple set associated with the prime number, the multiple in the multiple set is a positive integer, the multiple set comprises a value not equal to $A^x$, A is a positive integer greater than or equal to 2, and x is a nonnegative integer; and determining a check matrix based on the lifting factor and the base matrix, wherein the check matrix is used to encode or decode the information bit sequence.

2. The method according to claim 1, further comprising:

the base matrix being one of a plurality of base matrices;
determining the base matrix from the plurality of base matrices based on at least one of the length, a coding length, or a coding rate of the information bit sequence, wherein a base matrix in the plurality of base matrices corresponds to a lifting factor set in a plurality of lifting factor sets; and
determining, based on the base matrix, the lifting factor set corresponding to the base matrix.

3. The method according to claim 1 or 2, wherein determining the lifting factor comprises:

the prime number being one of a plurality of prime numbers;
determining, based on at least one of the coding length of the information bit sequence or an information column length of the base matrix, a minimum multiple corresponding to each prime number in the plurality of prime numbers corresponding to the plurality of lifting factor sets; and
determining the lifting factor based on a minimum value in products of all the prime numbers and the corresponding minimum multiples.

4. The method according to claim 3, wherein a minimum value in the plurality of prime numbers corresponding to the plurality of lifting factor sets is associated with at least one of the following:

a quantity of columns in a core part of the base matrix, wherein the core part comprises an information column and a core check column of the base matrix;
a connection relationship between the columns in the core part of the base matrix;
a quantity of rows in the core part of the base matrix; or
a connection relationship between the rows in the core part of the base matrix.

5. The method according to any one of claims 1 to 4, wherein the plurality of prime numbers corresponding to the plurality of lifting factor sets comprise at least one of the following:

consecutive prime numbers; or
non-consecutive prime numbers with an interval greater than a predetermined value.

6. The method according to claim 5, wherein the consecutive prime numbers comprise {11, 13, 17, 19, 23}; or
the non-consecutive prime numbers with the interval greater than the predetermined value comprise {11, 17, 23}.

7. The method according to any one of claims 1 to 6, wherein a maximum value in the multiple set is determined based on a maximum value of the lifting factor and the prime number; or
the maximum value in the multiple set is determined based on a maximum length of the information bit sequence, a quantity of information columns of the base matrix corresponding to the maximum length, and the prime number.

8. The method according to any one of claims 1 to 7, wherein the maximum value in the multiple set is associated with at least one of: a communication service type corresponding to the information bit sequence, or a hardware resource limitation.

9. The method according to any one of claims 1 to 8, wherein the multiple set comprises at least one of the following:

consecutive integers spaced by a predetermined interval;
an integer set satisfying a piecewise linear function;
a range of multiples; or
a number that is not selected as the multiple in the range.

10. The method according to any one of claims 1 to 9, further comprising:

determining two prime numbers corresponding to the lifting factor; and
selecting a minimum prime number from the two prime numbers.

11. The method according to any one of claims 1 to 10, wherein the lifting factor set further comprises a non-prime number, and the non-prime number comprises at least one of the following: 4, 6, 9, 15, 22, or 26.

**12.** The method according to any one of claims 1 to 11, wherein the lifting factor set further comprises an index associated with the prime number.

**13.** The method according to claim 12, further comprising:

> determining that the lifting factor corresponds to a plurality of indexes; and
> selecting an index corresponding to a minimum prime number in a plurality of prime numbers corresponding to the plurality of indexes.

**14.** The method according to claim 12 or 13, wherein a multiple set associated with a first index does not comprise a value of a prime number associated with a second index, and the second index is less than the first index; or
a multiple set associated with a first prime number does not comprise a value of a second prime number, and the second prime number is less than the first prime number.

**15.** The method according to any one of claims 1 to 14, further comprising:
determining, based on the communication service type corresponding to the information bit sequence, the lifting factor set corresponding to the communication service type, wherein the communication service type comprises an enhanced mobile broadband (eMBB) type, an ultra-reliable and low-latency communication (URLLC) type, or a high throughput type.

**16.** The method according to claim 15, wherein determining the lifting factor set comprises:

> for the communication service type being the high throughput type, determining that the prime number corresponding to the lifting factor set comprises 23, 31, or 37; or
> for the communication service type being the URLLC type, determining that the prime number corresponding to the lifting factor set comprises 11.

**17.** A communication device, comprising:

> a processor; and
> a memory, comprising computer program code, wherein
> when the computer program code is run by the processor, the method according to any one of claims 1 to 16 is performed.

**18.** A communication apparatus, comprising a component configured to perform the method according to any one of claims 1 to 16.

**19.** A computer-readable storage medium, comprising machine-executable instructions, wherein when the machine-executable instructions are executed by a device, the method according to any one of claims 1 to 16 is performed.

**20.** A computer program product, comprising a computer program, wherein when the computer program is run on an apparatus, the method according to any one of claims 1 to 16 is performed.

**21.** A communication system, comprising:

> a sending device, wherein the sending device performs the method according to claims 1 to 16, to encode a to-be-sent information bit sequence; and
> a receiving device, wherein the receiving device performs the method according to claims 1 to 16, to decode a received encoded information bit sequence.

FIG. 1

EP 4 773 527 A1

200

Source → Source encoding → Channel encoding → Modulation

Sink ← Source recovery ← Channel decoding ← Demodulation

FIG. 2

300

| High rate region | All-zero region |
| Incremental redundancy region | Raptor-like region |

FIG. 3A

| A | B | C |
| D | | E |

FIG. 3B

400

| Set index $(i_{LS})$ | Lifting factor set $(Z)$ |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

FIG. 4

500

| H_BG | | V_{i,j} | | | | | | | |
|---|---|---|---|---|---|---|---|---|---|
| Column index i | Row index j | Set index i_LS | | | | | | | |
| | | 0 | 1 | 2 | 3 | 4 | 5 | 6 | 7 |
| 0 | 0 | 250 | 307 | 73 | 223 | 211 | 294 | 0 | 135 |
| | 1 | 69 | 19 | 15 | 16 | 198 | 118 | 0 | 227 |
| | 2 | 226 | 50 | 103 | 94 | 188 | 167 | 0 | 126 |
| | 3 | 159 | 369 | 49 | 91 | 186 | 330 | 0 | 134 |
| | 5 | 100 | 181 | 240 | 74 | 219 | 207 | 0 | 84 |
| | 6 | 10 | 216 | 39 | 10 | 4 | 165 | 0 | 83 |
| | 9 | 59 | 317 | 15 | 0 | 29 | 243 | 0 | 53 |
| | 10 | 229 | 288 | 162 | 205 | 144 | 250 | 0 | 225 |
| | 11 | 110 | 109 | 215 | 216 | 116 | 1 | 0 | 205 |
| | 12 | 191 | 17 | 164 | 21 | 216 | 339 | 0 | 128 |
| | 13 | 9 | 357 | 133 | 215 | 115 | 201 | 0 | 75 |
| | 15 | 195 | 215 | 298 | 14 | 233 | 53 | 0 | 135 |
| | 16 | 23 | 106 | 110 | 70 | 144 | 347 | 0 | 217 |
| | 18 | 190 | 242 | 113 | 141 | 95 | 304 | 0 | 220 |
| | 19 | 35 | 180 | 16 | 198 | 216 | 167 | 0 | 90 |
| | 20 | 239 | 330 | 189 | 104 | 73 | 47 | 0 | 105 |
| | 21 | 31 | 346 | 32 | 81 | 261 | 188 | 0 | 137 |
| | 22 | 1 | 1 | 1 | 1 | 1 | 1 | 0 | 1 |
| | 23 | 0 | 0 | 0 | 0 | 0 | 0 | 0 | 0 |

FIG. 5

600A

| Prime number p | Multiple set t |
|---|---|
| 11 | 1, 2, ..., 34, 35 |
| 13 | 1, 2, ..., 29, 30 |
| 17 | 1, 2, ..., 22, 23 |
| 19 | 1, 2, ..., 20, 21 |
| 23 | 1, 2, ..., 16, 17 |

FIG. 6A

600B

| Index ID | Prime number p | Multiple set t |
|---|---|---|
| 0 | 11 | 1, 2, ..., 34, 35 |
| 1 | 13 | 1, 2, ..., 29, 30 |
| 2 | 17 | 1, 2, ..., 22, 23 |
| 3 | 19 | 1, 2, ..., 20, 21 |
| 4 | 23 | 1, 2, ..., 16, 17 |

FIG. 6B

600C

| Prime number set p1 | Set Z1 of values of lifting factors |
|---|---|
| 11, 13, 17, 19, 23 | 11, 13, 17, 19, 23, ..., 391 |

FIG. 6C

700

Sending device

Receiving device

711

712

713

714

710

720

730

FIG. 7

BGx

BG1

BG2

| Index ID | Prime number p | Multiple set t |
|---|---|---|
| 0 | 23 | 1, 2, ..., 17 |
| 1 | 29 | 1, 2, ..., 14 |
| 2 | 31 | 1, 2, ..., 13 |
| 3 | 37 | 1, 2, ..., 11 |
| 4 | 41 | 1, 2, ..., 10 |

| Index ID | Prime number p | Multiple set t |
|---|---|---|
| 0 | 11 | 1, 2, ..., 35 |
| 1 | 13 | 1, 2, ..., 30 |
| 2 | 17 | 1, 2, ..., 23 |
| 3 | 19 | 1, 2, ..., 21 |
| 4 | 23 | 1, 2, ..., 17 |

820

High throughput scenario

Others

URLLC scenario

Others

830

| Index ID | Prime number p | Multiple set t |
|---|---|---|
| 0 | 23 | 1, 2, ..., 17 |
| 2 | 31 | 1, 2, ..., 13 |
| 3 | 37 | 1, 2, ..., 11 |

| Index ID | Prime number p | Multiple set t |
|---|---|---|
| 0 | 23 | 1, 2, ..., 17 |
| 1 | 29 | 1, 2, ..., 14 |
| 2 | 31 | 1, 2, ..., 13 |
| 3 | 37 | 1, 2, ..., 11 |
| 4 | 41 | 1, 2, ..., 10 |

| Index ID | Prime number p | Multiple set t |
|---|---|---|
| 0 | 11 | 1, 2, ..., 35 |

840

835

| Index ID | Prime number p | Multiple set t |
|---|---|---|
| 0 | 11 | 1, 2, ..., 35 |
| 1 | 13 | 1, 2, ..., 30 |
| 2 | 17 | 1, 2, ..., 23 |
| 3 | 19 | 1, 2, ..., 21 |
| 4 | 23 | 1, 2, ..., 17 |

845

FIG. 8

EP 4 773 527 A1

FIG. 9A

900B

FIG. 9B

FIG. 10

1100

1101

Determine a lifting factor from lifting factor sets based on a length of an information bit sequence and a base matrix

1102

Determine a check matrix based on the lifting factor and the base matrix

FIG. 11

1200

1201

First processing component

1202

Second processing component

FIG. 12

1300

1310

Processor

1320
Memory

1322
RAM

1324
ROM

1330

FIG. 13

## INTERNATIONAL SEARCH REPORT

| International application No. |
| --- |
| **PCT/CN2023/120757** |

### A. CLASSIFICATION OF SUBJECT MATTER

H04L1/00(2006.01)i

According to International Patent Classification (IPC) or to both national classification and IPC

### B. FIELDS SEARCHED

Minimum documentation searched (classification system followed by classification symbols)

IPC:H04L1/-; H03M13/-

Documentation searched other than minimum documentation to the extent that such documents are included in the fields searched

Electronic data base consulted during the international search (name of data base and, where practicable, search terms used)

CNABS, CNTXT, CNKI, 万方, WANFANG: 低密度奇偶校验码, 提升因子, 扩展, 素数, 质数, 乘积, 相乘, 指数, 幂, 编码, 译码; VEN, ENTXT, 3GPP, IEEE: LDPC, low, density, parity, check, factor, expansion, prime, number, product, exponent, power, encode, decode

### C. DOCUMENTS CONSIDERED TO BE RELEVANT

| Category* | Citation of document, with indication, where appropriate, of the relevant passages | Relevant to claim No. |
| --- | --- | --- |
| X | CN 111565052 A (ZTE CORP.) 21 August 2020 (2020-08-21) description, paragraphs 109-111 and 136 | 1-21 |
| A | CN 111066253 A (HUAWEI TECHNOLOGIES CO., LTD.) 24 April 2020 (2020-04-24) entire document | 1-21 |
| A | CN 109951189 A (JINAN UNIVERSITY) 28 June 2019 (2019-06-28) entire document | 1-21 |
| A | US 2020112322 A1 (WESTERN DIGITAL TECHNOLOGIES, INC. et al.) 09 April 2020 (2020-04-09) entire document | 1-21 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **17 May 2024** | **21 May 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/120757**

| Patent document cited in search report | | | Publication date (day/month/year) | Patent family member(s) | | | Publication date (day/month/year) |
|---|---|---|---|---|---|---|---|
| CN | 111565052 | A | 21 August 2020 | US | 2019068224 | A1 | 28 February 2019 |
| | | | | US | 10523237 | B2 | 31 December 2019 |
| | | | | US | 2020136648 | A1 | 30 April 2020 |
| | | | | US | 11139835 | B2 | 05 October 2021 |
| | | | | EP | 3457574 | A1 | 20 March 2019 |
| | | | | EP | 3457574 | A4 | 08 May 2019 |
| | | | | WO | 2017193558 | A1 | 16 November 2017 |
| | | | | CN | 107370489 | A | 21 November 2017 |
| | | | | CN | 107370489 | B | 28 July 2020 |
| | | | | CN | 111565052 | A | 21 August 2020 |
| | | | | US | 2022038115A1 | A1 | 03 February 2022 |
| | | | | CN | 111565052 | B | 07 March 2023 |
| | | | | US | 11683051 | B2 | 20 June 2023 |
| CN | 111066253 | A | 24 April 2020 | BR | 112019027876 | A2 | 07 July 2020 |
| | | | | WO | 2019001477 | A1 | 03 January 2019 |
| | | | | IN | 202037001498 | A | 14 February 2020 |
| | | | | CN | CN111066253 | A | 24 April 2020 |
| CN | 109951189 | A | 28 June 2019 | CN | 109951189 | B | 31 March 2023 |
| US | 2020112322 | A1 | 09 April 2020 | US | 10897271 | B2 | 19 January 2021 |

Form PCT/ISA/210 (patent family annex) (July 2022)